# EUROPÄISCHE PATENTSCHRIFT

(11) **EP 3 681 890 B1**
(45) Veröffentlichungstag und Bekanntmachung des Hinweises auf die Patenterteilung: **18.08.2021**
(21) Anmeldenummer: 18762544.7
(22) Anmeldetag: 10.09.2018
(51) Int. Cl.: C07F 5/02, H01L 51/50, C09K 11/06

(54) **MATERIALIEN FÜR ORGANISCHE ELEKTROLUMINESZENZVORRICHTUNGEN**
MATERIALS FOR ORGANIC ELECTROLUMINESCENT DEVICES
MATÉRIAUX POUR DISPOSITIFS ÉLECTROLUMINESCENTS ORGANIQUES

(30) Priorität: 12.09.2017 EP 17190495
(43) Veröffentlichungstag der Anmeldung: 22.07.2020
(73) Patentinhaber: Merck Patent GmbH, 64293 Darmstadt (DE)
(72) Erfinder: PARHAM, Amir, 60486 Frankfurt Am Main (DE); KROEBER, Jonas, 60311 Frankfurt Am Main (DE); ENGELHART, Jens, 64285 Darmstadt (DE); JATSCH, Anja, 60489 Frankfurt Am Main (DE); EICKHOFF, Christian, 68259 Mannheim (DE); EHRENREICH, Christian, 64285 Darmstadt (DE)
(86) Internationale Anmeldenummer: PCT/EP2018/074253
(87) Internationale Veröffentlichungsnummer: WO 2019/052933

(56) Entgegenhaltungen:
- WO-A1-2006/117052
- WO-A1-2011/110262
- WO-A1-2011/116865
- US-A- 3 079 432

## Beschreibung

Die vorliegende Erfindung beschreibt cyclische Diazaborole insbesondere zur Verwendung als Triplettmatrixmaterialien in organischen Elektrolumineszenzvorrichtungen. Die Erfindung betrifft ferner ein Verfahren zur Herstellung der erfindungsgemäßen Verbindungen sowie elektronische Vorrichtungen enthaltend diese Verbindungen.

Im Stand der Technik werden in US3079432 Verfahren zur Herstellung von Amino(phenyl)boranen genannt, jedoch ohne eine Verwendung in OLEDs zu offenbaren. WO2011/110262 beschreibt Verbindungen zur Verwendung in OLEDs, bei denen eine Boreinheit als Brückenglied zwischen zwei aromatischen Zyklen fungiert. WO2006/117052 offenbart Diazoborole für den Einsatz in elektronischen Vorrichtungen. WO2011/110262 beschreibt polyzyklische Verbindungen, enthaltend Bor als Brückenglied zwischen zwei Zyklen für den Einsatz in elektronischen Vorrichtungen. Als emittierende Materialien in organischen Elektrolumineszenzvorrichtungen (OLEDs) werden häufig metallorganische Komplexe eingesetzt, die Phosphoreszenz zeigen. Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, insbesondere auch bei OLEDs, die Phosphoreszenz zeigen, immer noch Verbesserungsbedarf, beispielsweise im Hinblick auf Effizienz, Betriebsspannung und Lebensdauer.
Die Eigenschaften phosphoreszierender OLEDs werden nicht nur von den eingesetzten Triplettemittern bestimmt. Hier sind insbesondere auch die anderen verwendeten Materialien, wie zum Beispiel Matrixmaterialien, von besonderer Bedeutung. Verbesserungen dieser Materialien können somit auch zu deutlichen Verbesserungen der OLED-Eigenschaften führen. Generell besteht bei diesen Materialien für die Verwendung als Matrixmaterialien noch Verbesserungsbedarf, insbesondere in Bezug auf die Lebensdauer und Oxidationsempfindlichkeit, aber auch in Bezug auf die Effizienz und die Betriebsspannung der Vorrichtung.
Aufgabe der vorliegenden Erfindung ist die Bereitstellung von Verbindungen, welche sich für den Einsatz in einer phosphoreszierenden oder fluoreszierenden OLED eignen, insbesondere als Matrixmaterial. Insbesondere ist es die Aufgabe der vorliegenden Erfindung, Matrixmaterialien bereitzustellen, welche sich für rot, orange, gelb und grün phosphoreszierende OLEDs und gegebenenfalls auch für blau phosphoreszierende OLEDs eignen und die zu hoher Lebensdauer, guter Effizienz und geringer Betriebsspannung führen. Gerade auch die Eigenschaften der Matrixmaterialien haben einen wesentlichen Einfluss auf die Lebensdauer und die Effizienz der organischen Elektrolumineszenzvorrichtung.

Es wurde überraschend gefunden, dass Elektrolumineszenzvorrichtungen, die Verbindungen gemäß der folgenden Formel (1) enthalten, Verbesserungen gegenüber dem Stand der Technik aufweisen, insbesondere beim Einsatz als Matrixmaterial für phosphoreszierende Dotanden.

Gegenstand der vorliegenden Erfindung ist daher eine Verbindung gemäß der folgenden Formel (1), 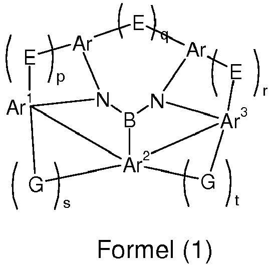 wobei für die verwendeten Symbole und Indizes gilt:
- E: ist bei jedem Auftreten gleich oder verschieden ausgewählt aus der Gruppe bestehend aus einer Einfachbindung, NR, CR₂, O, S oder C=O;
- G: ist bei jedem Auftreten gleich oder verschieden ausgewählt aus der Gruppe bestehend aus NR, CR₂, O, S oder C=O;
- p, q, r: sind bei jedem Auftreten gleich oder verschieden und sind ausge-wählt aus der Gruppe bestehend aus 0, 1 oder 2;
- s, t: sind bei jedem Auftreten gleich oder verschieden und sind ausge-wählt aus der Gruppe bestehend aus 0 oder 1;
- R: ist bei jedem Auftreten gleich oder verschieden ausgewählt aus der Gruppe bestehend aus H, D, F, Cl, Br, I, CN, NO₂, N(Ar⁴)₂, N(R¹)₂, OAr⁴, OR¹, SAr⁴, SR¹, C(=O)Ar⁴, C(=O)R¹, P(=O)(Ar⁴)₂, P(Ar⁴)₂, B(Ar⁴)₂, einer geradkettigen Alkyl-, Alkoxy- oder Thioalkyl-gruppe mit 1 bis 40 C-Atomen oder einer verzweigten oder cyclischen Alkyl-, Alkoxy- oder Thioalkylgruppe mit 3 bis 40 C-Atomen oder einer Alkenylgruppe oder Alkinylgruppe mit 2 bis 40 C-Atomen, die jeweils mit einem oder mehreren Resten R¹ substituiert sein kann und wobei eine oder mehrere nicht-benachbarte CH₂-Gruppen durch R¹C=CR¹, C=O, C=S, C=NR¹, P(=O)(R¹), SO, SO₂, NR¹, O, S oder CONR¹ ersetzt sein können und wobei ein oder mehrere H-Atome durch D, F, Cl, Br, I, CN oder NO₂ ersetzt sein können, einem aromatischen oder heteroaromatischen Ring-system mit 5 bis 60 aromatischen Ringatomen, das jeweils mit einem oder mehreren Resten R¹ substituiert sein kann, oder einer Aralkyl- oder Heteroaralkylgruppe mit 5 bis 60 aromatischen Ring-atomen, die mit einem oder mehreren Resten R¹ substituiert sein kann, oder einer Kombination dieser Systeme; dabei können optional zwei oder mehr Substituenten R, die bevorzugt an das-selbe Kohlenstoffatom oder an benachbarte Kohlenstoffatome gebunden sind, ein monocyclisches oder polycyclisches, alipha-tisches, heteroaliphatisches, aromatisches oder heteroaroma-tisches Ringsystem bilden, das mit einem oder mehreren Resten R¹ substituiert sein kann;
- Ar, Ar¹, Ar², Ar³: sind bei jedem Auftreten gleich oder verschieden ein aromatisches oder heteroaromatisches Ringsystem mit 5 bis 40 aromatischen Ringatomen, welches mit einem oder mehreren Resten R substituiert sein kann, wobei für q gleich 0 beide Ar zusammen auch für eine mit mindestens beiden N-Atomen ver-bundene Gruppe Ar stehen kann;
- Ar⁴: ist bei jedem Auftreten gleich oder verschieden ein aromatisches oder heteroaromatisches Ringsystem mit 5 bis 40 aromatischen Ringatomen, welches mit einem oder mehreren Resten R² substi-tuiert sein kann, dabei können zwei Reste Ar⁴, welche an das-selbe N-Atom oder P-Atom binden, auch durch eine Einfach-bindung oder eine Brücke ausgewählt aus N(R²), C(R²)₂, O oder S, miteinander verbrückt sein;
- R¹: ist bei jedem Auftreten gleich oder verschieden ausgewählt aus der Gruppe bestehend aus H, D, F, Cl, Br, I, CN, NO₂, N(R²)₂, OR², SR², C(=O)R², einer geradkettigen Alkyl-, Alkoxy- oder Thio-alkylgruppe mit 1 bis 20 C-Atomen oder einer verzweigten oder cyclischen Alkyl-, Alkoxy- oder Thioalkylgruppe mit 3 bis 20 C-Atomen oder einer Alkenylgruppe oder Alkinylgruppe mit 2 bis 20 C-Atomen, die jeweils mit einem oder mehreren Resten R² substituiert sein kann und wobei eine oder mehrere nicht-benachbarte CH₂-Gruppen durch R²C=CR², C=O, C=S, C=NR², P(=O)(R²), SO, SO₂, NR², O, S oder CONR² ersetzt sein können und wobei ein oder mehrere H-Atome durch D, F, Cl, Br, I, CN oder NO₂ ersetzt sein können, einem aromatischen oder heteroaromatischen Ring-system mit 5 bis 40 aromatischen Ringatomen, das jeweils mit einem oder mehreren Resten R² substituiert sein kann, oder einer Aralkyl- oder Heteroaralkylgruppe mit 5 bis 40 aromatischen Ring-atomen, die mit einem oder mehreren Resten R² substituiert sein kann; dabei können optional zwei Substituenten R¹, die an das gleiche Kohlenstoffatom oder an benachbarte Kohlenstoffatome gebunden sind, ein monocyclisches oder polycyclisches, aliphatisches, heteroaliphatisches, aromatisches oder heteroaromatisches Ringsystem bilden, das mit einem oder mehreren Resten R² substituiert sein kann; und
- R²: ist bei jedem Auftreten gleich oder verschieden ausgewählt aus der Gruppe bestehend aus H, D, F, CN, einem aliphatischen Kohlenwasserstoffrest mit 1 bis 20 C-Atomen oder einem aromatischen oder heteroaromatischen Ringsystem mit 5 bis 30 aromatischen Ringatomen, in dem ein oder mehrere H-Atome durch D, F oder CN oder durch ein oder mehrere Alkylgruppen mit jeweils 1 bis 10 Kohlenstoffatomen substituiert sein kann; dabei können zwei oder mehr benachbarte Substituenten R² miteinander ein mono- oder polycyclisches, aliphatisches, aromatisches oder heteroaromatisches Ringsystem bilden.

Dabei bedeutet p, q oder r = 0, dass die entsprechende Gruppe E nicht vorhanden ist. Weiterhin bedeutet s oder t = 0, dass die entsprechende Gruppe G nicht vorhanden ist.

Benachbarte Atome, insbesondere Kohlenstoffatome, im Sinne der vorliegenden Erfindung sind Atome, die direkt miteinander verknüpft sind.

Unter der Formulierung, dass zwei oder mehr Reste miteinander einen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht. 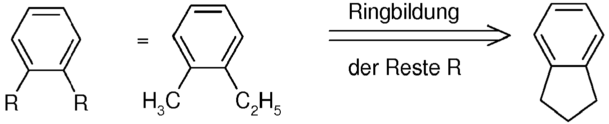 Weiterhin soll unter der oben genannten Formulierung auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

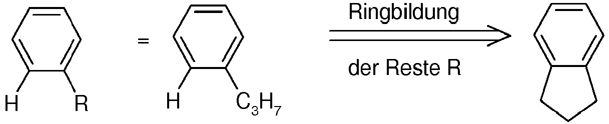

Eine kondensierte Arylgruppe im Sinne der vorliegenden Erfindung ist eine Gruppe, in der zwei oder mehr aromatische Gruppen über eine gemeinsame Kante aneinander ankondensiert, d. h. anelliert, sind, wie beispielsweise im Naphthalin. Dagegen ist beispielsweise Fluoren keine kondensierte Arylgruppe im Sinne der vorliegenden Erfindung, da im Fluoren die beiden aromatischen Gruppen keine gemeinsame Kante aufweisen. Gleiches gilt für kondensierte Heteroarylgruppen.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 40 C-Atome im Ringsystem. Ein heteroaromatisches Ringsystem im Sinne dieser Erfindung enthält 1 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy oder 2,2,2-Trifluorethoxy verstanden. Unter einer Thioalkylgruppe mit 1 bis 40 C-Atomen werden insbesondere Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden. Allgemein können Alkyl-, Alkoxy- oder Thioalkylgruppen gemäß der vorliegenden Erfindung geradkettig, verzweigt oder cyclisch sein, wobei eine oder mehrere nicht-benachbarte CH₂-Gruppen durch die oben genannten Gruppen ersetzt sein können; weiterhin können auch ein oder mehrere H-Atome durch D, F, Cl, Br, I, CN oder NO₂, bevorzugt F, Cl oder CN, weiter bevorzugt F oder CN, besonders bevorzugt CN ersetzt sein.

Unter einem aromatischen oder heteroaromatischen Ringsystem bevorzugt mit 5 - 40 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

In einer bevorzugten Ausführungsform stehen s und t jeweils für 0. Damit werden die jeweiligen Gruppen Ar¹, Ar² und Ar³ nur durch jeweils eine Einfachbindung miteinander verbunden, aber nicht durch eine zusätzliche Gruppe G.

In einer bevorzugten Ausführungsform sind p und r bei jedem Auftreten gleich oder verschieden und ausgewählt aus 0 oder 1, und q ist ausgewählt aus 0, 1 oder 2.

Bevorzugt ist in Ar¹ und Ar³ die jeweilige Einfachbindung zu Ar² benachbart zum jeweiligen N-Atom an Ar¹, bzw. Ar³, also in ortho-Stellung.

Bevorzugt sind die Einfachbindungen zu Ar¹ und Ar², sowie die Bindung zum B-Atom an Ar³ benachbart, also in ortho-Stellung.

Bevorzugt ist in Ar¹ und Ar³ die jeweilige Einfachbindung zu Ar² benachbart zum jeweiligen N-Atom an Ar¹, bzw. Ar³ als auch die Einfachbindungen zu Ar¹ und Ar², sowie die Bindung zum Bor-Atom an Ar³ benachbart. Dadurch bilden Ar¹, Ar² zusammen mit B und N, sowie Ar³ und Ar² zusammen mit B und N jeweils einen Sechsring.

In einer weiteren Ausführungsform der Erfindung ist die Verbindung ausgewählt aus Verbindungen der Formel (2), 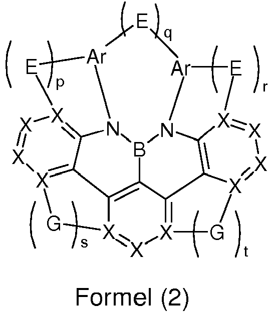 wobei Symbole und Indizes den Symbolen und Indizes von Formel (1) entsprechen und zusätzlich gilt:
- X: ist bei jedem Auftreten gleich oder verschieden CR oder N, oder genau zwei benachbarte Gruppen X stehen zusammen für eine Gruppe ausgewählt aus NR, O oder S und die verbleibenden X stehen gleich oder verschieden für CR oder N, wodurch ein Fünfring entsteht; dabei steht X für C oder N oder genau zwei X stehen für N, wenn dort eine Bindung zu E oder G ist; mit der Maßgabe, dass maximal 3 X, bevorzugt maximal 2 X in einem Cyclus für N stehen.

In einer bevorzugten Ausführungsform der Erfindung ist die Verbindung ausgewählt aus den Verbindungen der Formeln (2-1) bis (2-3), 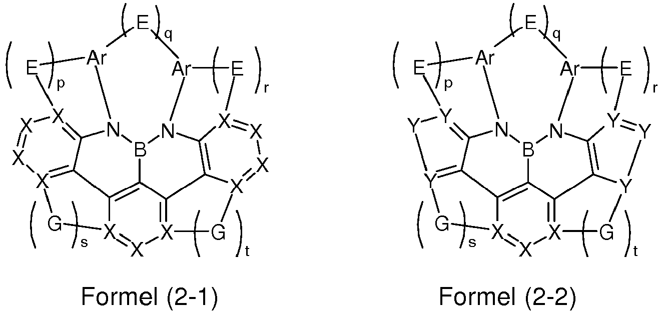 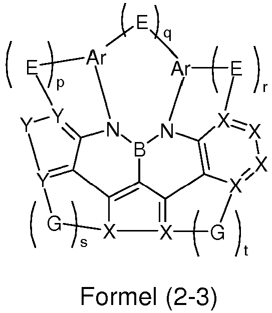 wobei die Symbole und Indizes die oben genannten Bedeutungen aufweisen und zusätzlich gilt:
- X: ist bei jedem Auftreten gleich oder verschieden CR oder N, wobei X für C steht, wenn dort eine Bindung zu E oder G ist, und wobei maximal 2 X in einem Cyclus für N stehen; und
- Y: ist bei jedem Auftreten gleich oder verschieden CR, NR, O oder S, wobei Y auch N sein kann, wenn in dem gleichen Cyclus bereits ein Y für NR, O oder S steht, wobei Y für C oder N steht, wenn dort eine Bindung zu E ist.

In einer besonders bevorzugten Ausführungsform ist die Verbindung eine Verbindung der Formel (2-1). Besonders bevorzugt stehen in den Formeln (2-1), (2-2) und (2-3) alle X für CR oder für C, falls eine Bindung zu E oder G dort angeordnet ist.

In einer weiteren bevorzugten Ausführungsform steht die Verbindung für eine Verbindung der Formel (3-1) bis (3-6), 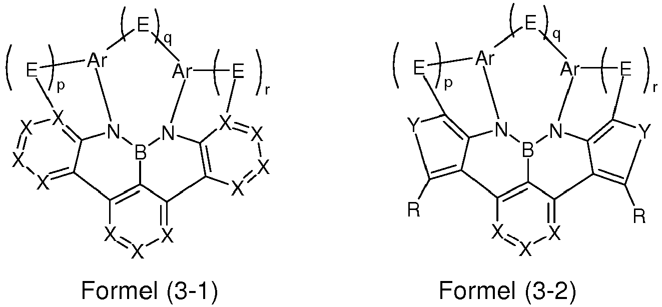 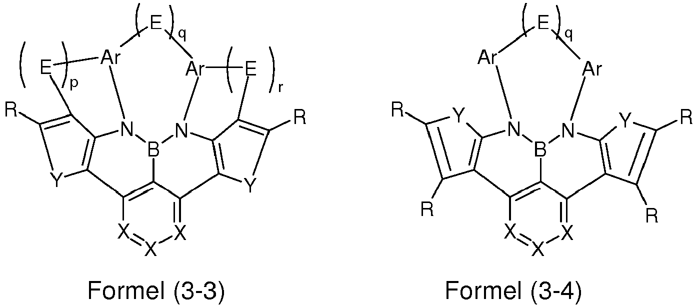 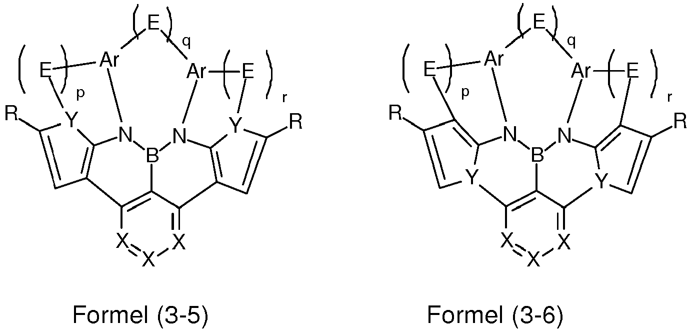 wobei zusätzlich zu den Formeln (2-1) bis (2-3) Folgendes gilt:
- Y: ist in Formeln (3-1) bis (3-4) bei jedem Auftreten gleich oder verschieden NR, O oder S und ist in Formeln (3-5) und (3-6) NR, O oder S, wenn die an Y gebundene Gruppe E nicht vorhanden ist, also der entsprechende Index p bzw. r = 0 ist, bzw. ist N, wenn die an Y gebundene Gruppe E vorhanden ist, also der entsprechende Index p bzw. r = 1 oder 2 ist.

In einer bevorzugten Ausführungsform ist die Verbindung eine Verbindung gemäß einer der Formeln (3-1) bis (3-6), wie vorstehend angegeben, wobei für p oder r gleich 0 jeweils eine Gruppe R statt der Bindung zu E vorhanden ist.

In einer weiteren bevorzugten Ausführungsform der Erfindung steht Ar gleich oder verschieden bei jedem Auftreten für ein aromatisches oder heteroaromatisches Ringsystem mit 6 bis 24 aromatischen Ringatomen, bevorzugt mit 6 bis 18 aromatischen Ringatomen, besonders bevorzugt für ein aromatisches Ringsystem mit 6 bis 12 aromatischen Ringatomen bzw. ein heteroaromatisches Ringsystem mit 6 bis 13 aromatischen Ringatomen, das jeweils durch einen oder mehrere Reste R substituiert sein kann, bevorzugt aber unsubstituiert ist, wobei Ar bevorzugt Arylgruppen oder Heteroarylgruppen mit bis zu 15 aromatischen Ringatomen umfasst. Beispiele für geeignete Gruppen Ar sind ausgewählt aus der Gruppe bestehend aus Phenyl, ortho-, meta- oder para-Biphenyl, Terphenyl, insbesondere verzweigtes Terphenyl, Quaterphenyl, insbesondere verzweigtes Quaterphenyl, 1-, 2-, 3- oder 4-Fluorenyl, 1-, 2-, 3- oder 4-Spirobifluorenyl, Pyridyl, Pyrimidinyl, Triazinyl, 1-, 2-, 3- oder 4-Dibenzofuranyl und 1-, 2-, 3- oder 4-Dibenzothienyl, die jeweils durch einen oder mehrere Reste R substituiert sein können, bevorzugt aber unsubstituiert sind.

In einer bevorzugten Ausführungsform der Erfindung ist Ar ausgewählt aus den Strukturen der Formeln (Ar-1) bis (Ar-21), 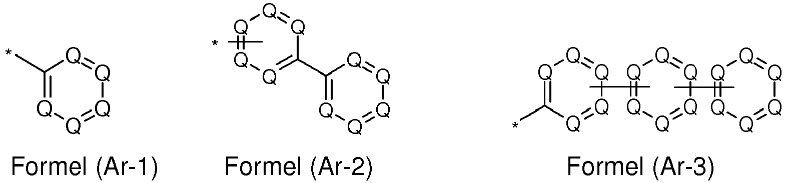 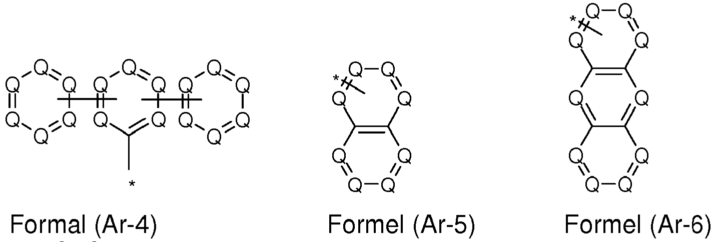 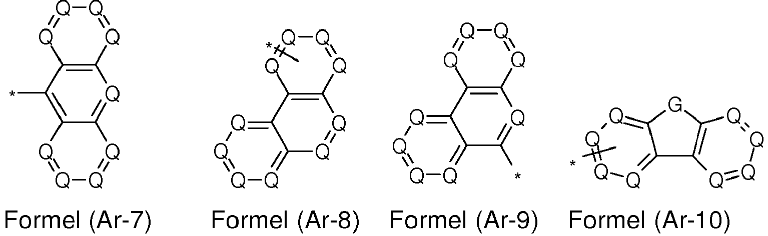 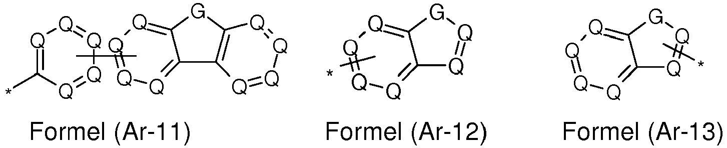 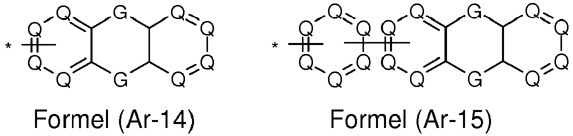 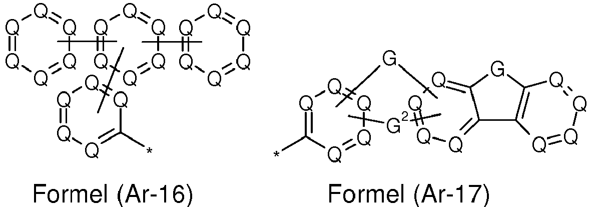 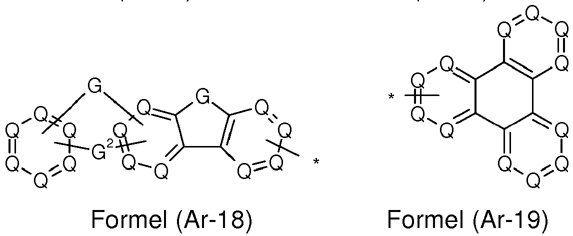 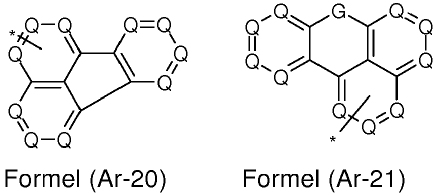 wobei die Symbole den Symbolen der Formel (1) entsprechen, * die Bindung zum Stickstoffatom darstellt und zusätzlich gilt:
- Q: ist bei jedem Auftreten gleich oder verschieden CR oder N, wobei maximal 3 Symbole Q pro Cyclus für N stehen;
- G²: ist bei jedem Auftreten eine Einfachbindung, NR, (CR)₂, O, S oder C=O.

In einer weiteren bevorzugten Ausführungsform ist die Gruppe Ar bei jedem Auftreten ausgewählt aus den Gruppen mit den Strukturen der Formeln (Ar-1) bis (Ar-21), wobei die allgemeinen Formeln durch die besonders bevorzugten Ausführungsformen jeweils gemäß der folgenden Formeln (Ar-1-1) bis (Ar-16-6) ersetzt werden (z. B. wird Formel (Ar-1) durch eine der Formeln (Ar-1-1) bis (Ar-1-9) ersetzt): 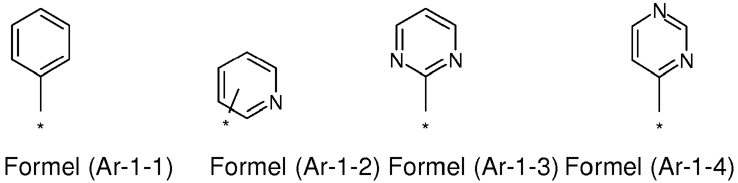 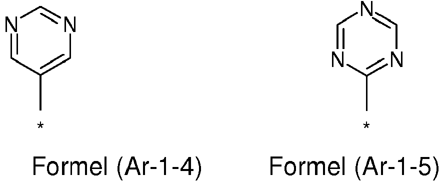 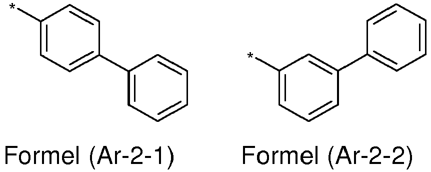 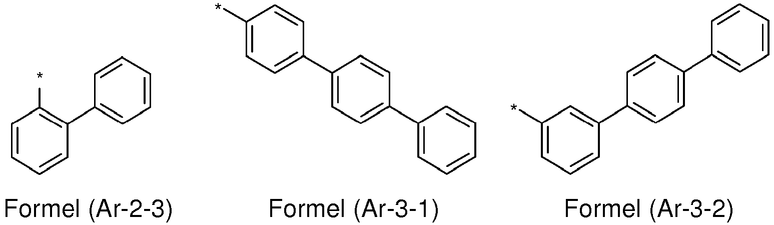 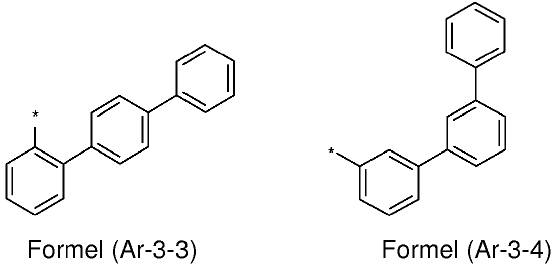 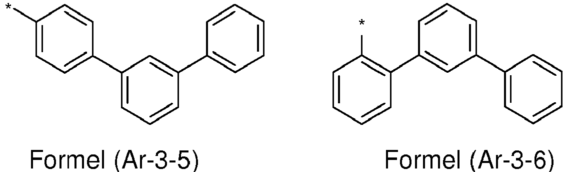 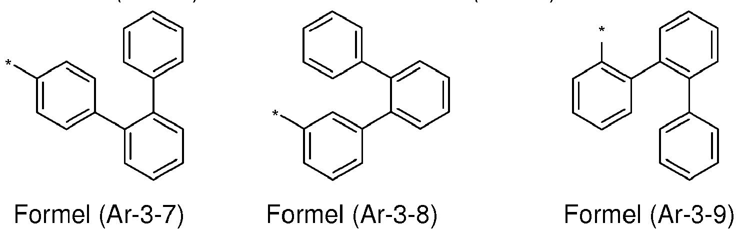 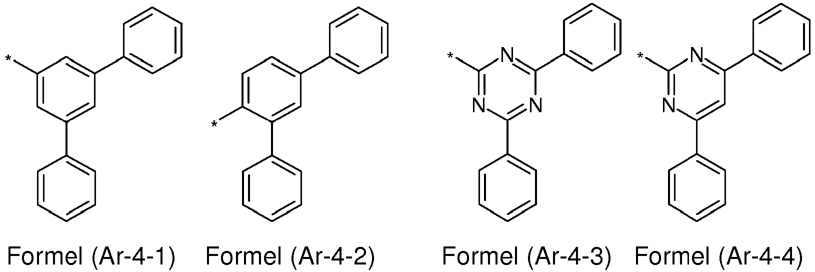 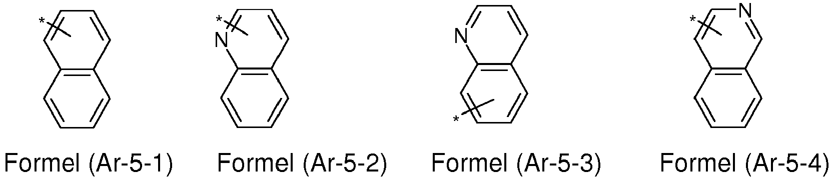 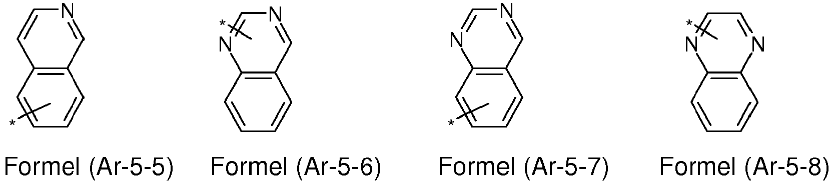 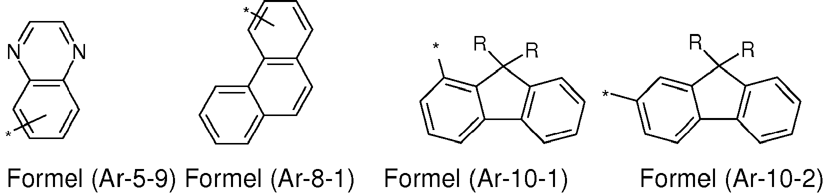 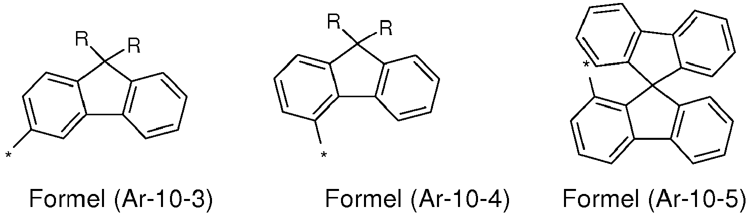 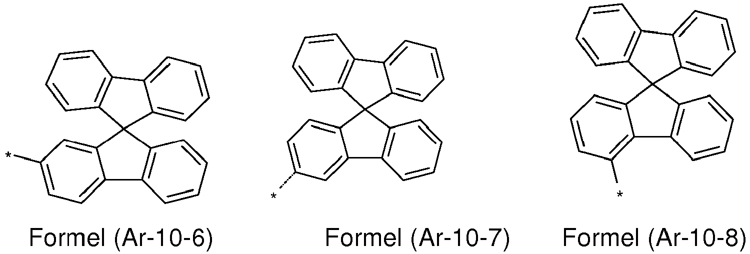 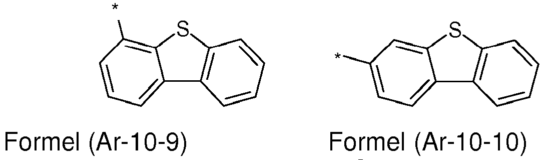 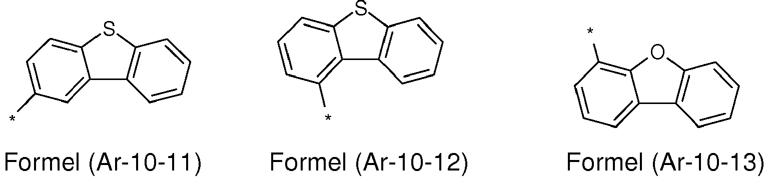 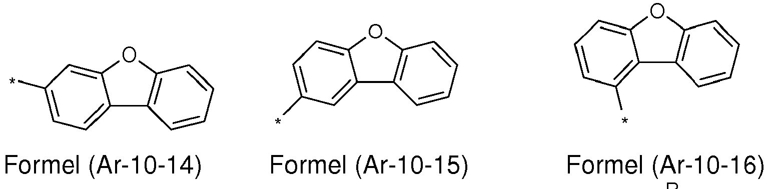 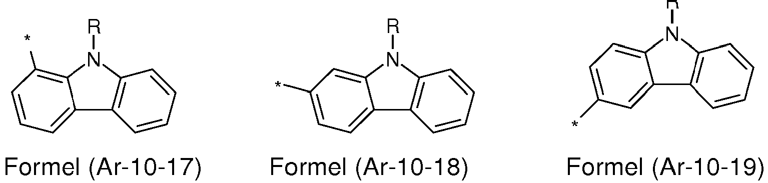 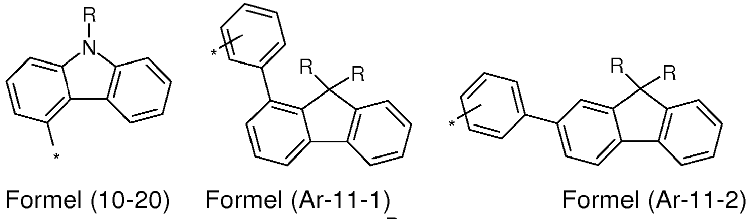 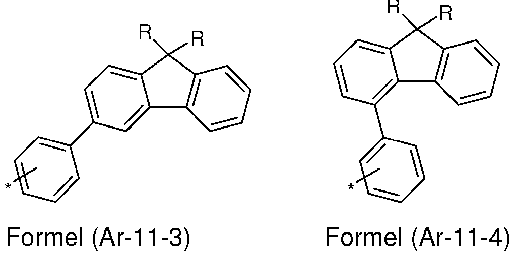 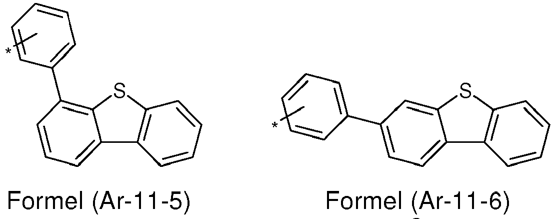 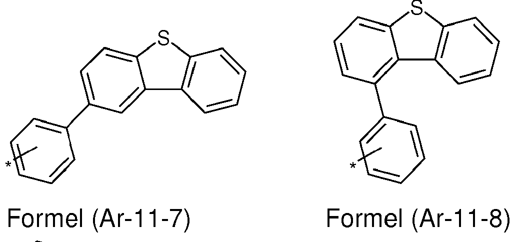 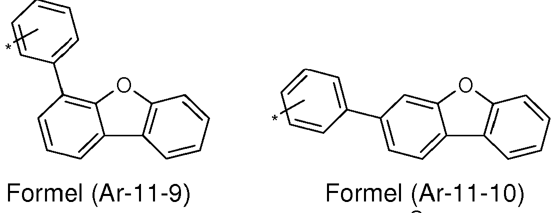 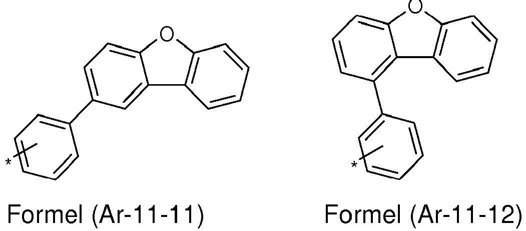 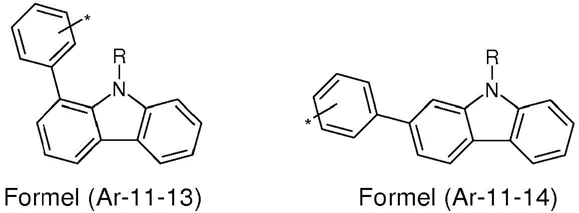 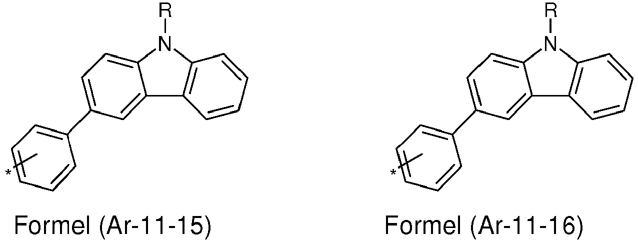 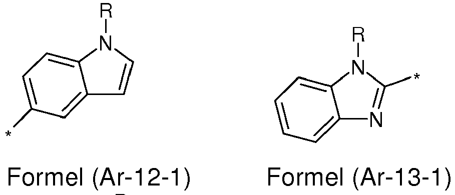 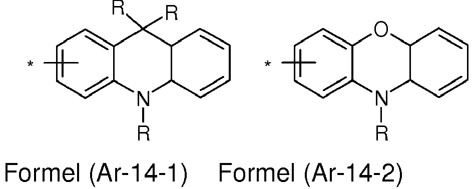 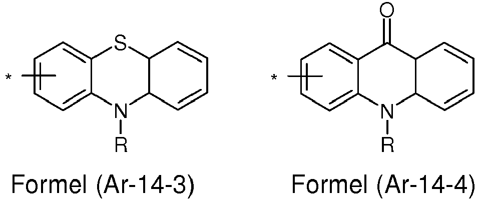 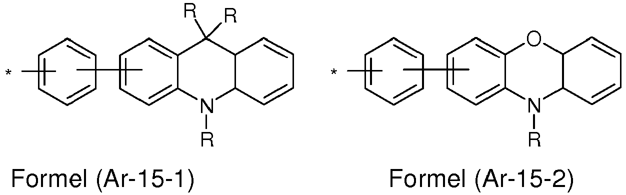 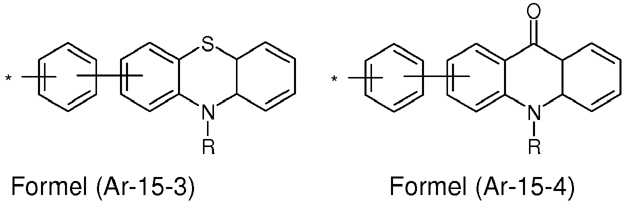 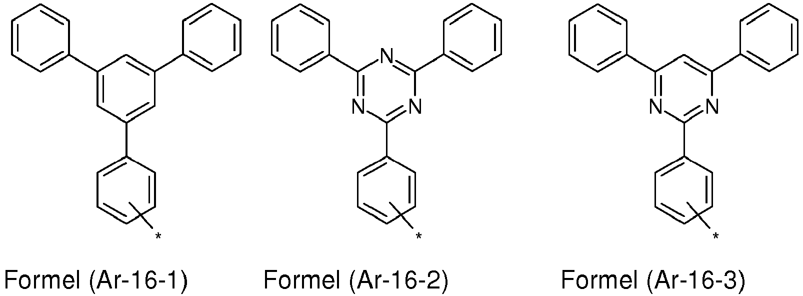 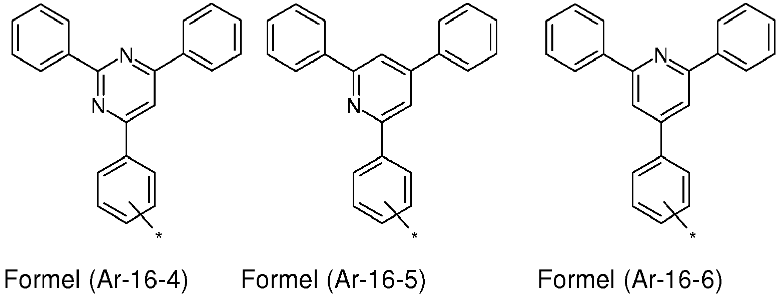 wobei die Symbole den Symbolen in Formel (Ar-1) bis (Ar-21) entsprechen. Die Formeln können an den freien Positionen mit R substituiert sein sowie entsprechende Bindungen zu der Gruppe E, soweit vorhanden, aufweisen.

In einer weiteren Ausführungsform der Erfindung ist die Verbindung eine Verbindung der Formeln (4-1) bis (4-12), 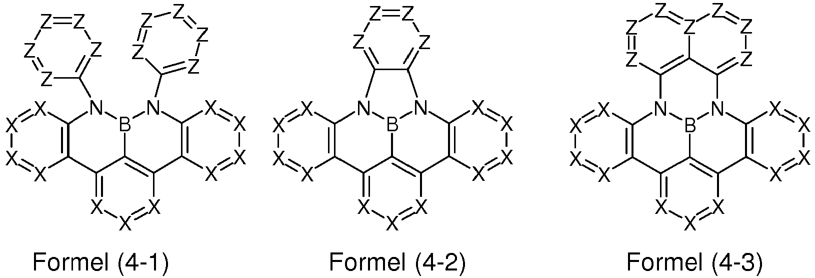 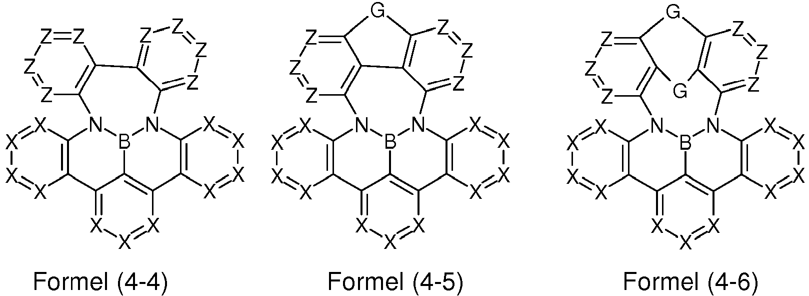 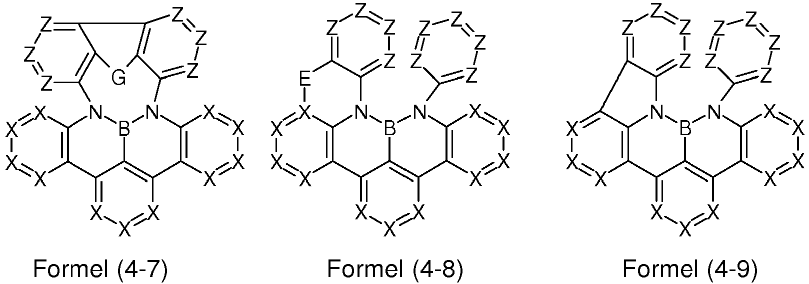 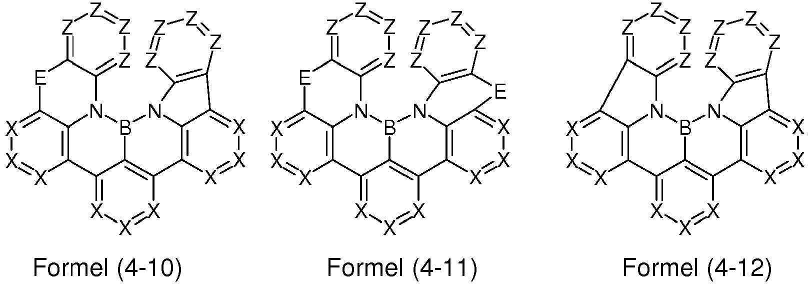 wobei die Symbole den Symbolen der Formel (1) entsprechen und zusätzlich gilt:
- G: ist bei jedem Auftreten gleich oder verschieden ausgewählt aus NR, (CR)₂, O, S oder C=O;
- X: ist bei jedem Auftreten gleich oder verschieden CR, N oder genau zwei benachbarte Gruppen X stehen zusammen für eine Gruppe ausgewählt aus NR, O oder S, wodurch ein Fünfring entsteht; dabei stehen maximal 3 X, bevorzugt maximal 2 X in einem Cyclus für N;
- Z: ist bei jedem Auftreten gleich oder verschieden CR, N oder genau zwei benachbarte Gruppen Z stehen zusammen für eine Gruppe ausgewählt aus NR, O oder S, wodurch ein Fünfring entsteht; dabei stehen maximal 3 Z, bevorzugt maximal 2 Z in einem Cyclus für N.

In einer bevorzugten Ausführungsform der Erfindung gilt für X und Z Folgendes:
- X: ist bei jedem Auftreten gleich oder verschieden CR, N oder genau zwei benachbarte Gruppen X stehen zusammen für eine Gruppe ausgewählt aus NR, O oder S, wodurch ein Fünfring entsteht; dabei stehen maximal 3 X, bevorzugt maximal 2 X in einem Cyclus für N;
- Z: ist bei jedem Auftreten gleich oder verschieden CR oder N, wobei maximal 3 Z, bevorzugt maximal 2 Z in einem Cyclus für N stehen.

In einer weiteren bevorzugten Ausführungsform der Erfindung gilt für X und Z Folgendes:
- X: ist bei jedem Auftreten gleich oder verschieden CR;
- Z: ist bei jedem Auftreten gleich oder verschieden CR oder N, wobei maximal 3 Z, bevorzugt maximal 2 Z in einem Cyclus für N stehen.

Besonders bevorzugt sind Verbindungen der Formeln (4-1) und (4-8) bis (4-12).

In einer bevorzugten Ausführungsform sind die Gruppen R, wenn sie nicht für H oder D stehen, in para-Stellung zum Stickstoff oder zum Bor gebunden, besonders bevorzugt in para-Stellung zum Stickstoff.

In einer weiteren bevorzugten Ausführungsform ist die Verbindung eine Verbindung der Formel (5), 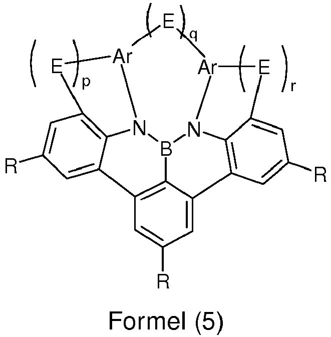 wobei die Symbole und Indizes der Formel (3-1) entsprechen.

In einer bevorzugten Ausführungsform der Erfindung ist q gleich 0, und an jedes N ist eine Gruppe Ar gebunden. Besonders bevorzugt sind gleichzeitig auch p und r = 0.

In einer weiteren bevorzugten Ausführungsform ist mindestens einer der Indizes p, q und/oder r = 1 und die weiteren Indizes p, q und r sind gleich 0. Besonders bevorzugte Ausführungsformen sind dabei die folgenden Ausführungsformen:
- p = r = 1 und q = 0; oder
- p = 1 und q = r = 0; oder
- p = r = 0 und q = 1.

Besonders bevorzugt sind die Substituenten R, die an Ar, Ar¹, Ar² bzw. Ar³ gebunden sind, gleich oder verschieden bei jedem Auftreten ausgewählt aus der Gruppe bestehend aus H, D, F, CN, N(Ar⁴)₂, einer geradkettigen Alkylgruppe mit 1 bis 8 C-Atomen, bevorzugt mit 1, 2, 3 oder 4 C-Atomen, oder einer verzweigten oder cyclischen Alkylgruppe mit 3 bis 8 C-Atomen, bevorzugt mit 3, 4, 5 oder 6 C-Atomen, oder einer Alkenylgruppe mit 2 bis 8 C-Atomen, bevorzugt mit 2, 3 oder 4 C-Atomen, die jeweils mit einem oder mehreren Resten R¹ substituiert sein kann, bevorzugt aber unsubstituiert ist, oder einem aromatischen oder heteroaromatischen Ringsystem mit 6 bis 24 aromatischen Ringatomen, bevorzugt mit 6 bis 18 aromatischen Ringatomen, besonders bevorzugt mit 6 bis 13 aromatischen Ringatomen, das jeweils mit einem oder mehreren Resten R¹ substituiert sein kann, bevorzugt aber unsubstituiert ist; dabei können optional zwei Substituenten R, die an benachbarte Kohlenstoffatome gebunden sind, ein monocyclisches oder polycyclisches, aliphatisches Ringsystem bilden, das mit einem oder mehreren Resten R¹ substituiert sein kann, bevorzugt aber unsubstituiert ist.

In einer weiteren Ausführungsform der Erfindung ist R bei jedem Auftreten gleich oder verschieden im Falle eines aromatischen oder heteroaromatischen Ringsystems gleich oder verschieden bei jedem Auftreten ausgewählt aus den Strukturen der Formeln (Ar-1) bis (Ar-21), wobei die Formeln statt mit R jeweils mit R¹ substituiert sind und * entsprechend die Bindung an das Grundgerüst bzw. an E oder G bedeutet.

In einer weiteren bevorzugten Ausführungsform ist die Gruppe R bei jedem Auftreten im Falle eines aromatischen oder heteroaromatischen Ringsystems gleich oder verschieden bei jedem Auftreten ausgewählt aus den Gruppen mit den Strukturen der Formeln (Ar-1) bis (Ar-21), wobei die allgemeinen Formeln durch die besonders bevorzugten Ausführungsformen jeweils gemäß der folgenden Formeln (Ar-1-1) bis (Ar-16-6) ersetzt werden (z. B. wird Formel (Ar-1) durch eine der Formeln (Ar-1-1) bis (Ar-1-9) ersetzt). Wie vorstehend angegeben, werden dabei alle R durch R¹ ersetzt.

Besonders bevorzugt sind die Substituenten R¹ gleich oder verschieden bei jedem Auftreten ausgewählt aus der Gruppe bestehend aus H, D, F, CN, N(R²)₂, einer geradkettigen Alkylgruppe mit 1 bis 8 C-Atomen, bevorzugt mit 1, 2, 3 oder 4 C-Atomen, oder einer verzweigten oder cyclischen Alkylgruppe mit 3 bis 8 C-Atomen, bevorzugt mit 3, 4, 5 oder 6 C-Atomen, oder einer Alkenylgruppe mit 2 bis 8 C-Atomen, bevorzugt mit 2, 3 oder 4 C-Atomen, die jeweils mit einem oder mehreren Resten R² substituiert sein kann, bevorzugt aber unsubstituiert ist, oder einem aromatischen oder heteroaromatischen Ringsystem mit 6 bis 24 aromatischen Ringatomen, bevorzugt mit 6 bis 18 aromatischen Ringatomen, besonders bevorzugt mit 6 bis 13 aromatischen Ringatomen, das jeweils mit einem oder mehreren Resten R² substituiert sein kann, bevorzugt aber unsubstituiert ist; dabei können optional zwei Substituenten R¹ die an dasselbe Kohlenstoffatom oder an benachbarte Kohlenstoffatome gebunden sind, ein monocyclisches oder polycyclisches, aliphatisches Ringsystem bilden, das mit einem oder mehreren Resten R² substituiert sein kann, bevorzugt aber unsubstituiert ist.

In einer weiteren Ausführungsform der Erfindung ist R¹ bei jedem Auftreten gleich oder verschieden im Falle eines aromatischen oder heteroaromatischen Ringsystems gleich oder verschieden bei jedem Auftreten ausgewählt aus den Strukturen der Formeln (Ar-1) bis (Ar-21), wobei die Formeln statt mit R jeweils mit R² substituiert sind und * entsprechend die Bindung zu R bedeutet, wobei die Bindung zu R auch statt wie angegeben auch über G oder G² erfolgen kann, wenn diese für NR stehen, wobei dann R durch Bindung an R substituiert wird.

In einer weiteren bevorzugten Ausführungsform ist die Gruppe R¹ bei jedem Auftreten im Falle eines aromatischen oder heteroaromatischen Ringsystems gleich oder verschieden bei jedem Auftreten ausgewählt aus den Gruppen mit den Strukturen der Formeln (Ar-1) bis (Ar-21), wobei die allgemeinen Formeln durch die besonders bevorzugten Ausführungsformen jeweils gemäß der folgenden Formeln (Ar-1-1) bis (Ar-16-6) ersetzt werden (z. B. wird Formel (Ar-1) durch eine der Formeln (Ar-1-1) bis (Ar-1-9) ersetzt). Wie vorstehend angegeben, werden dabei alle R durch R² ersetzt.

Wenn E bzw. G oder G² für CR₂ steht, ist es bevorzugt, wenn die Reste R, die an dieses Kohlenstoffatom gebunden sind, bei jedem Auftreten gleich oder verschieden für eine geradkettige Alkylgruppe mit 1 bis 8 C-Atomen, bevorzugt mit 1, 2, 3 oder 4 C-Atomen, oder eine verzweigte oder cyclische Alkylgruppe mit 3 bis 8 C-Atomen, bevorzugt mit 3, 4, 5 oder 6 C-Atomen, oder eine Alkenylgruppe mit 2 bis 8 C-Atomen, bevorzugt mit 2, 3 oder 4 C-Atomen, stehen, die jeweils mit einem oder mehreren Resten R¹ substituiert sein kann, wobei eine oder mehrere nicht-benachbarte CH₂-Gruppen durch O ersetzt sein können und wobei ein oder mehrere H-Atome durch D oder F ersetzt sein können, oder für ein aromatisches oder heteroaromatisches Ringsystem mit 6 bis 24 aromatischen Ringatomen, bevorzugt mit 6 bis 18 aromatischen Ringatomen, besonders bevorzugt mit 6 bis 13 aromatischen Ringatomen, das jeweils mit einem oder mehreren Resten R¹ substituiert sein kann, stehen; dabei können optional die beiden Substituenten R ein monocyclisches oder polycyclisches, aliphatisches, aromatisches oder heteroaromatisches Ringsystem bilden, das mit einem oder mehreren Resten R¹ substituiert sein kann. Durch Ringbildung der beiden Substituenten R wird ein Spirosystem aufgespannt, beispielsweise ein Spirobifluoren bzw. Derivat eines Spirobifluorens, wenn die Gruppen R für Phenylgruppen stehen.

Wenn E bzw. G oder G² für NR steht, ist es bevorzugt, wenn der Rest R, der an dieses Stickstoffatom gebunden ist, bei jedem Auftreten gleich oder verschieden für ein aromatisches oder heteroaromatisches Ringsystem mit 5 bis 24 aromatischen Ringatomen steht, das jeweils mit einem oder mehreren Resten R¹ substituiert sein kann, besonders bevorzugt für ein aromatisches oder heteroaromatisches Ringsystem mit 6 bis 18 aromatischen Ringatomen, bevorzugt mit 6 bis 13 aromatischen Ringatomen, das mit einem oder mehreren Resten R¹ substituiert sein kann. Beispiele für geeignete Substituenten R sind ausgewählt aus der Gruppe bestehend aus Phenyl, ortho-, meta- oder para-Biphenyl, Terphenyl, insbesondere verzweigtes Terphenyl, Quaterphenyl, insbesondere verzweigtes Quaterphenyl, 1-, 2-, 3- oder 4-Fluorenyl, 1-, 2-, 3- oder 4-Spirobifluorenyl, Pyridyl, Pyrimidinyl, 1,3,5-Triazinyl, 4,6-Diphenyl-1,3,5-triazinyl, 1-, 2-, 3- oder 4-Dibenzofuranyl, 1-, 2-, 3- oder 4-Dibenzothienyl und 1-, 2-, 3- oder 4-Carbazolyl, wobei die Carbazolylgruppe am Stickstoffatom durch einen Rest R¹ ungleich H oder D substituiert ist. Dabei können diese Gruppen jeweils durch einen oder mehrere Reste R¹ substituiert sein, sind bevorzugt aber unsubstituiert.

Die oben genannten Bevorzugungen können einzeln oder gemeinsam auftreten. Es ist bevorzugt, wenn die oben genannten Bevorzugungen gemeinsam auftreten.

Beispiele für geeignete erfindungsgemäße Verbindungen sind die nachstehend gezeigten Strukturen.

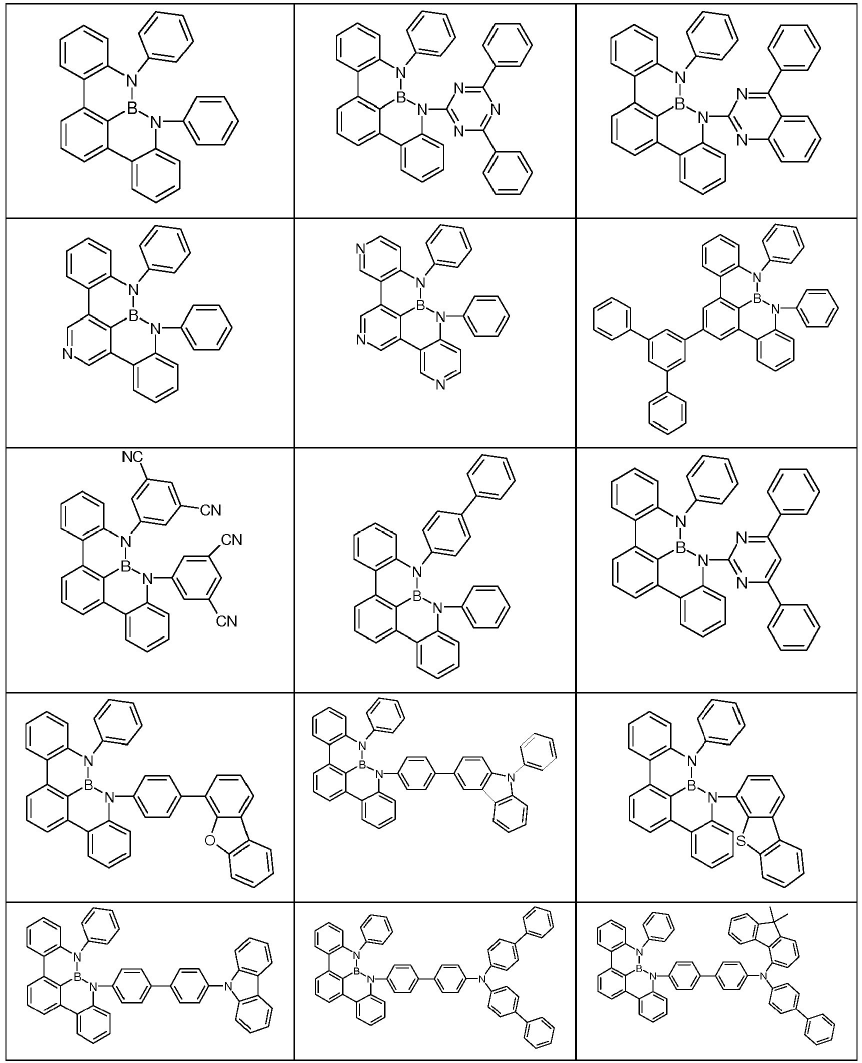

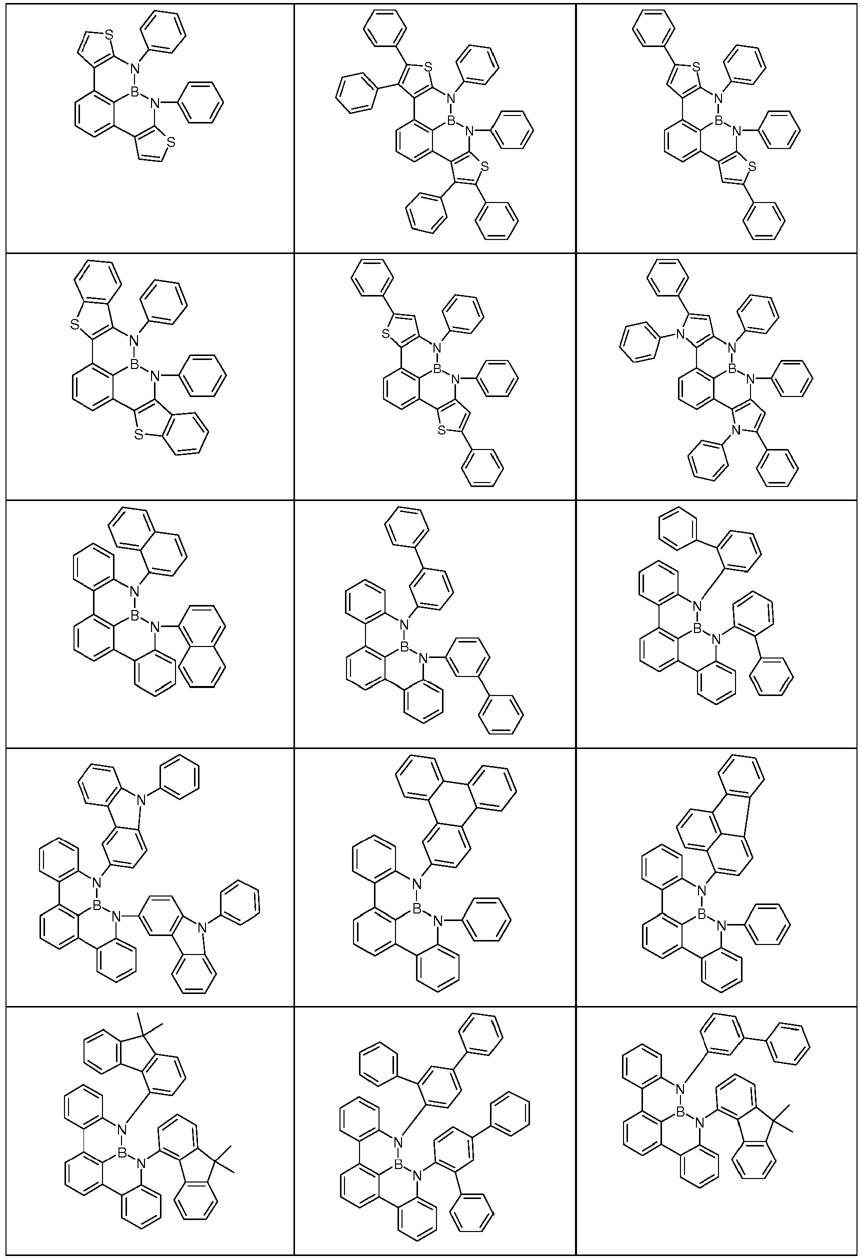

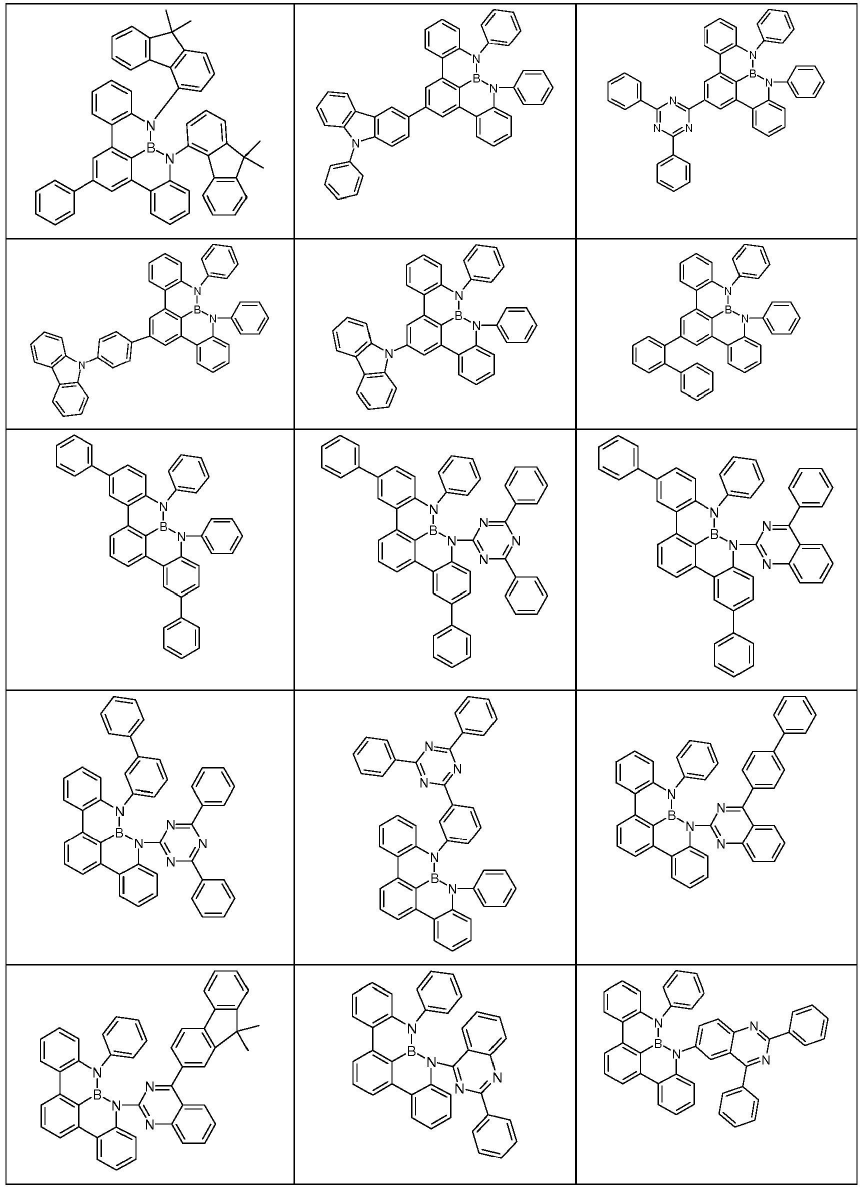

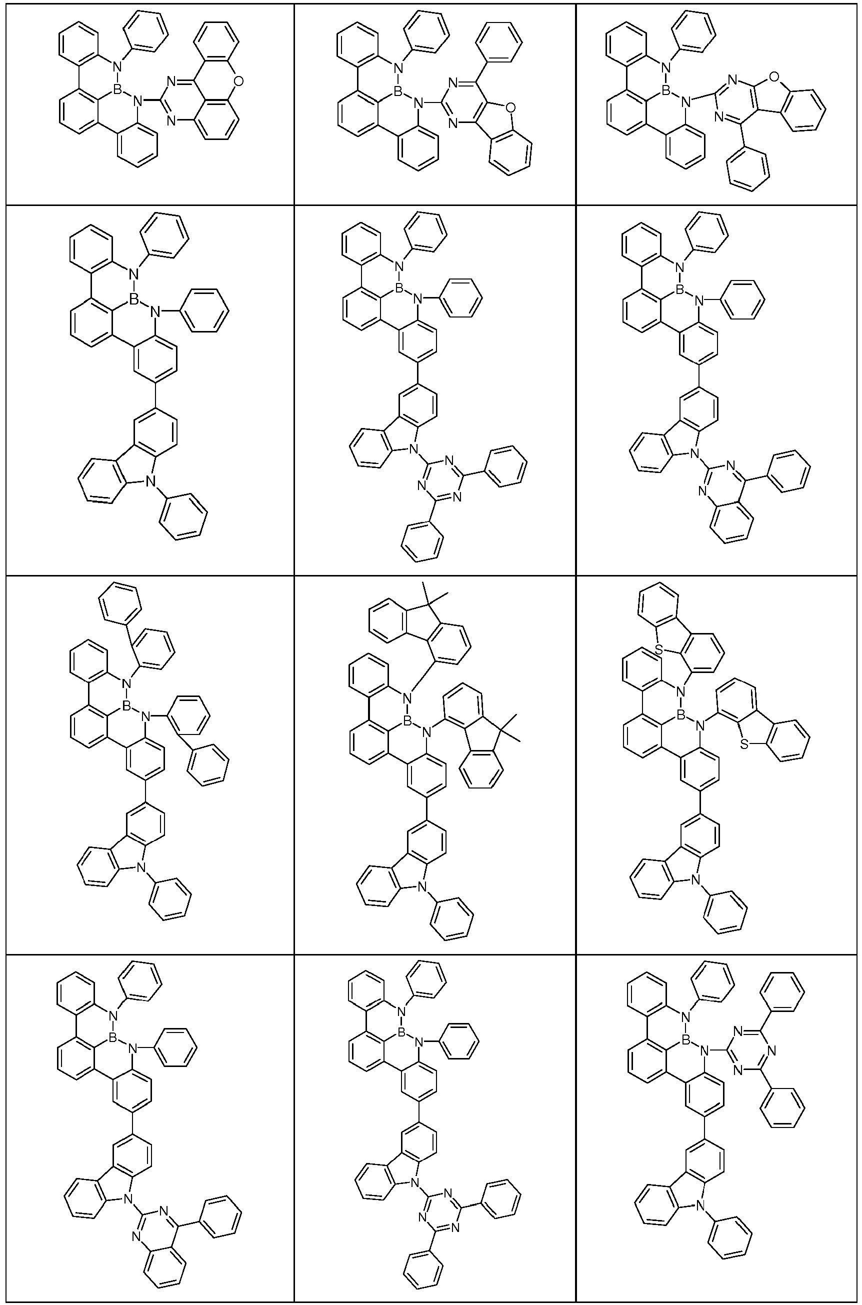

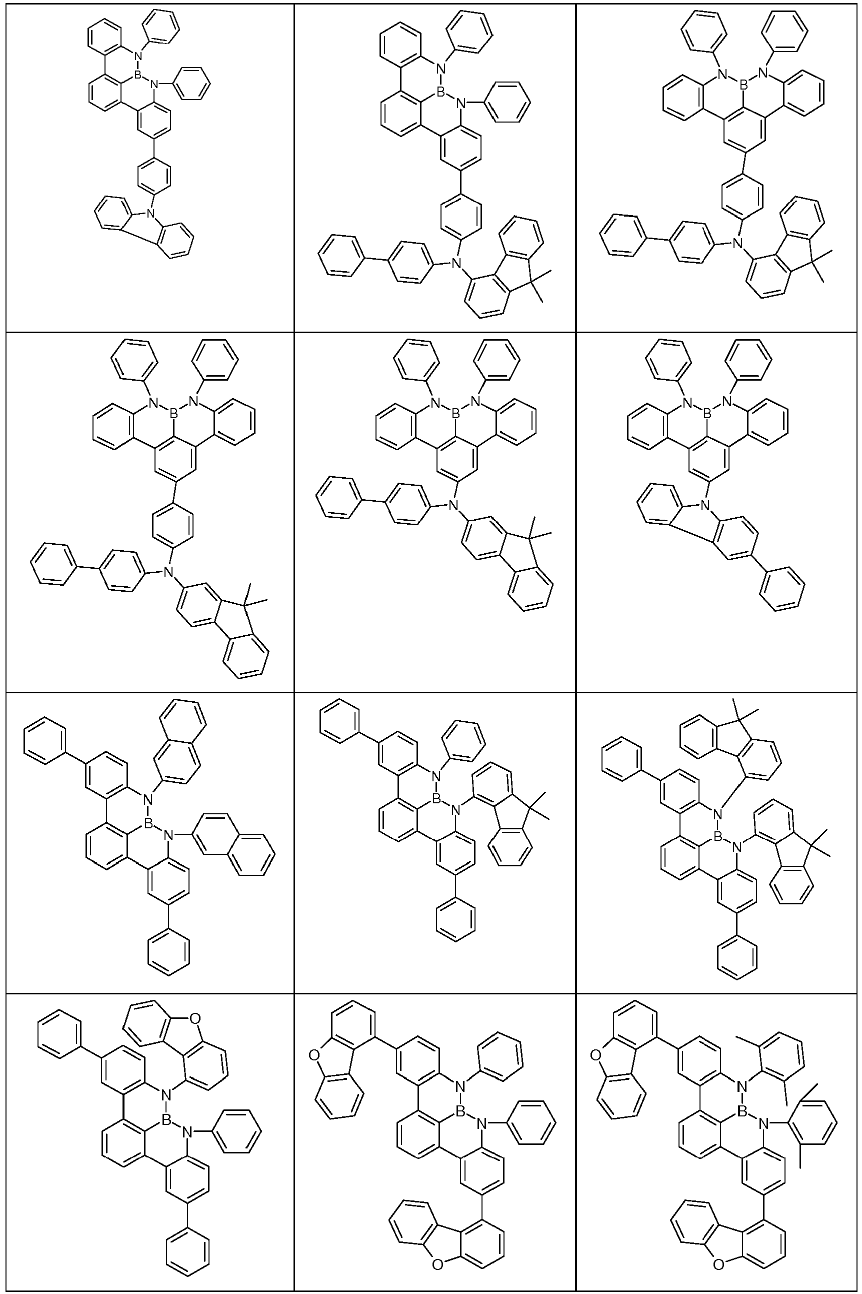

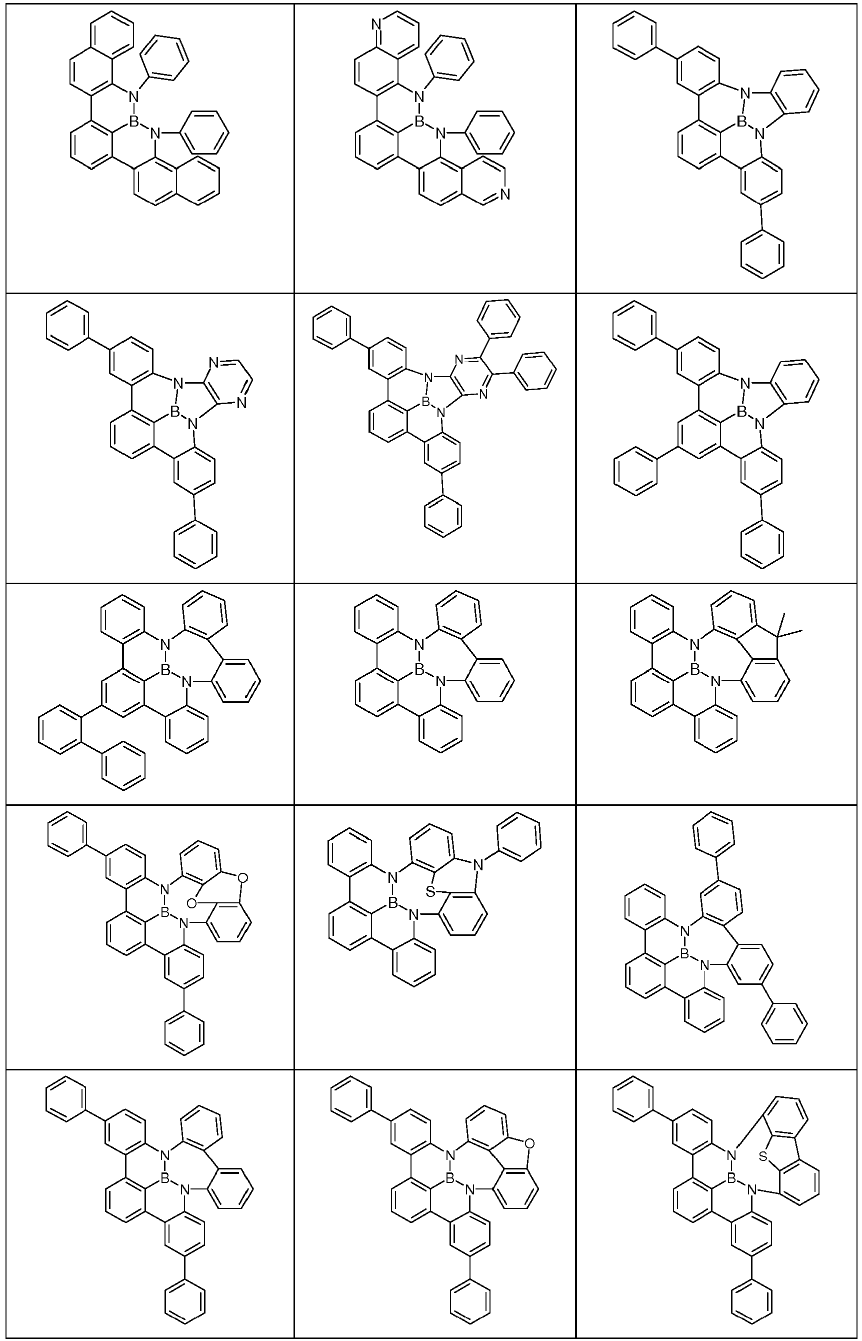

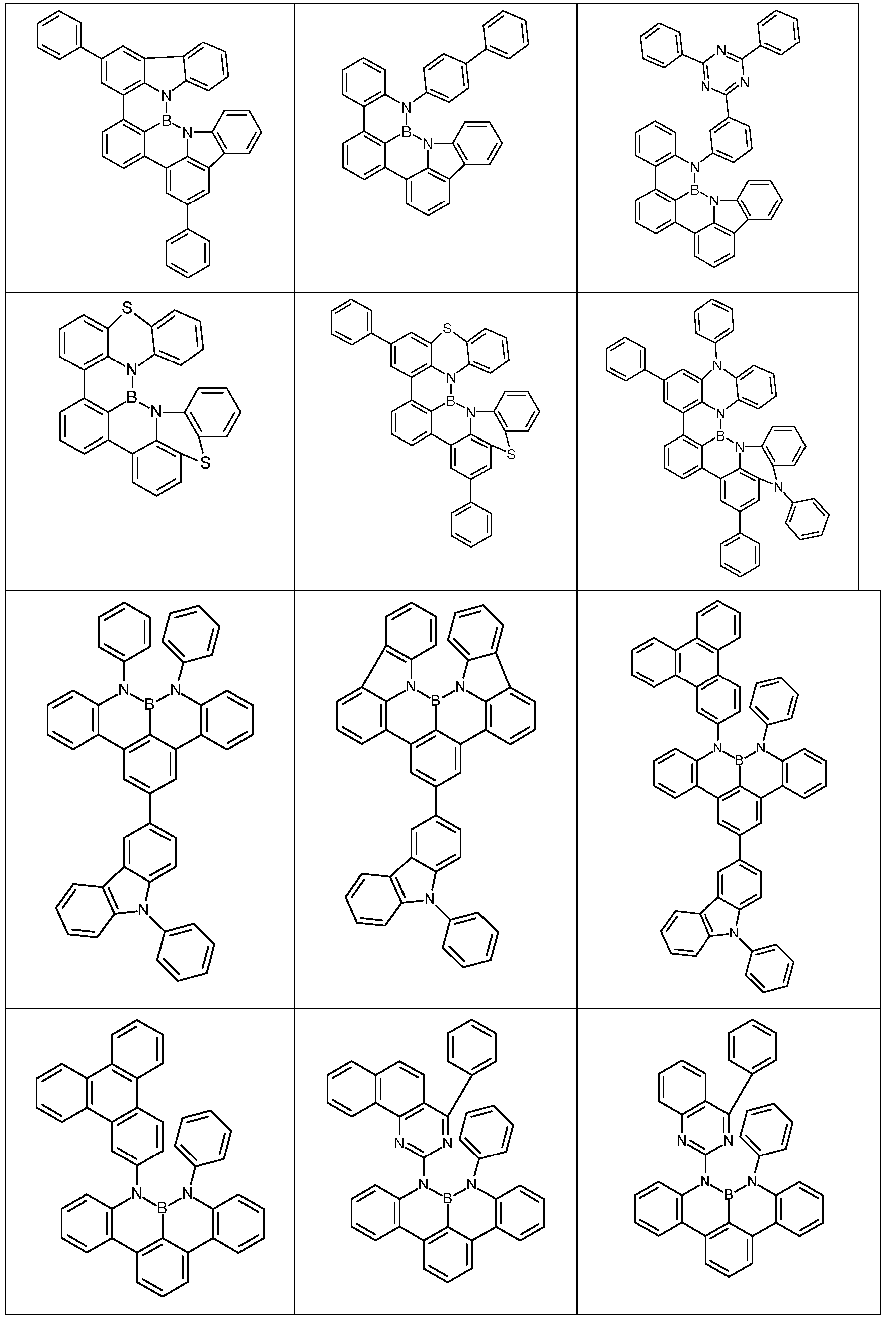

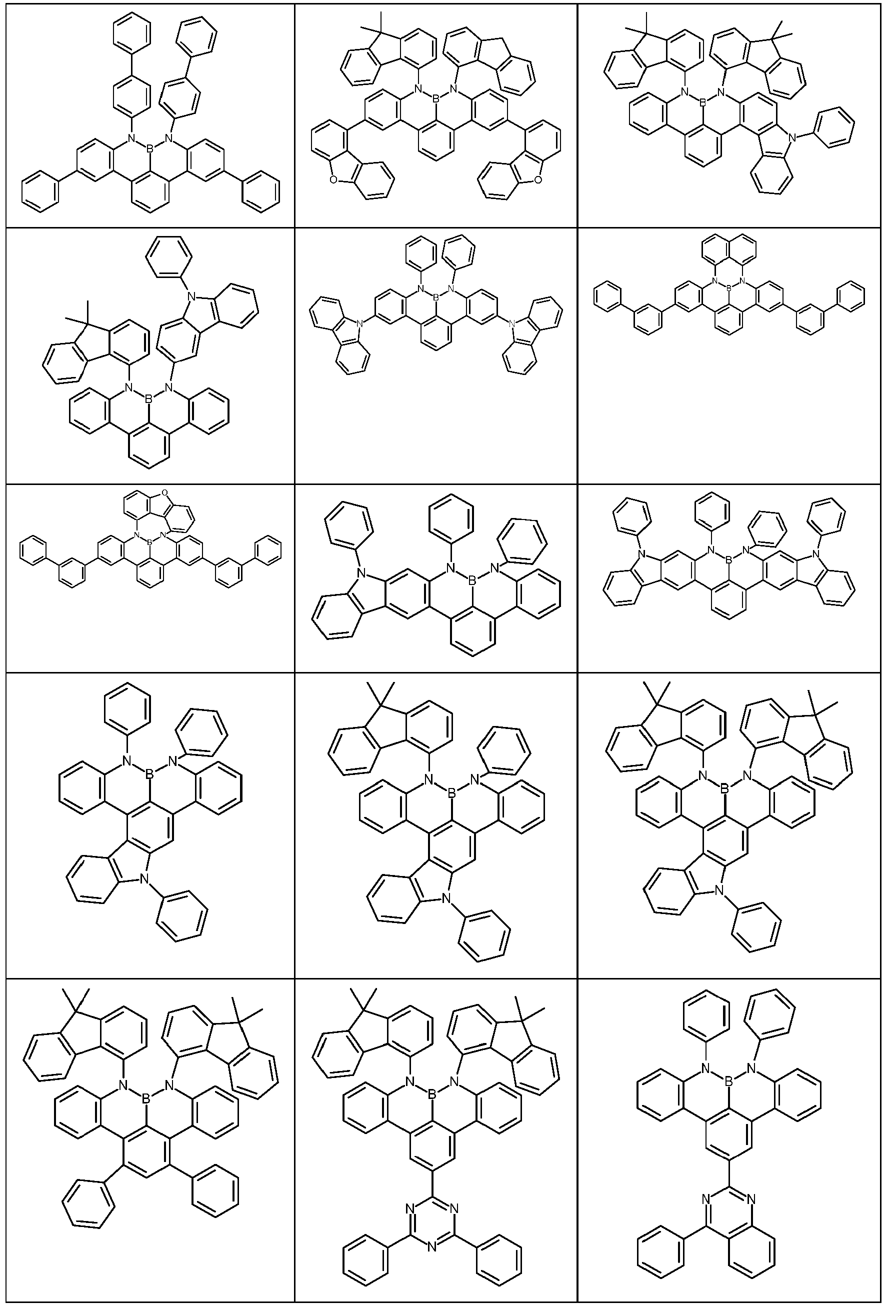

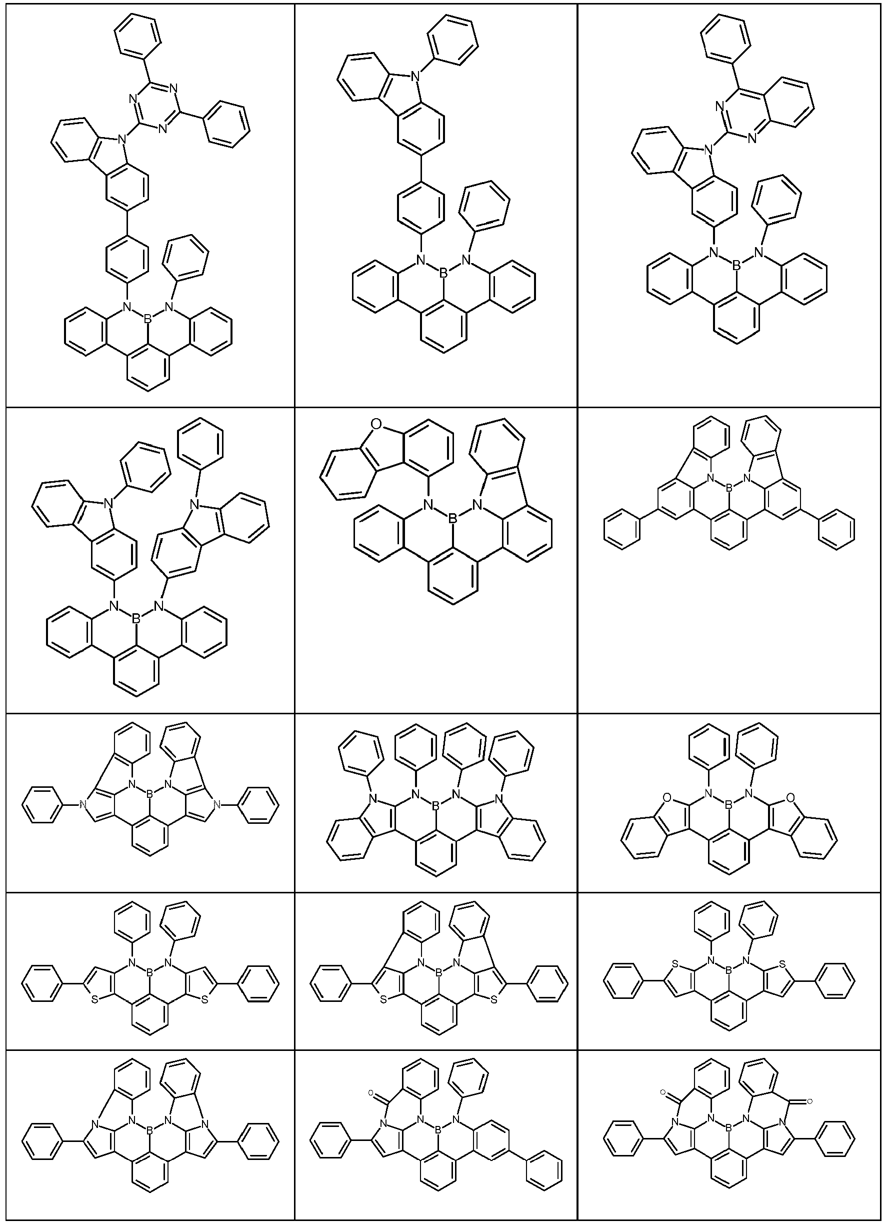

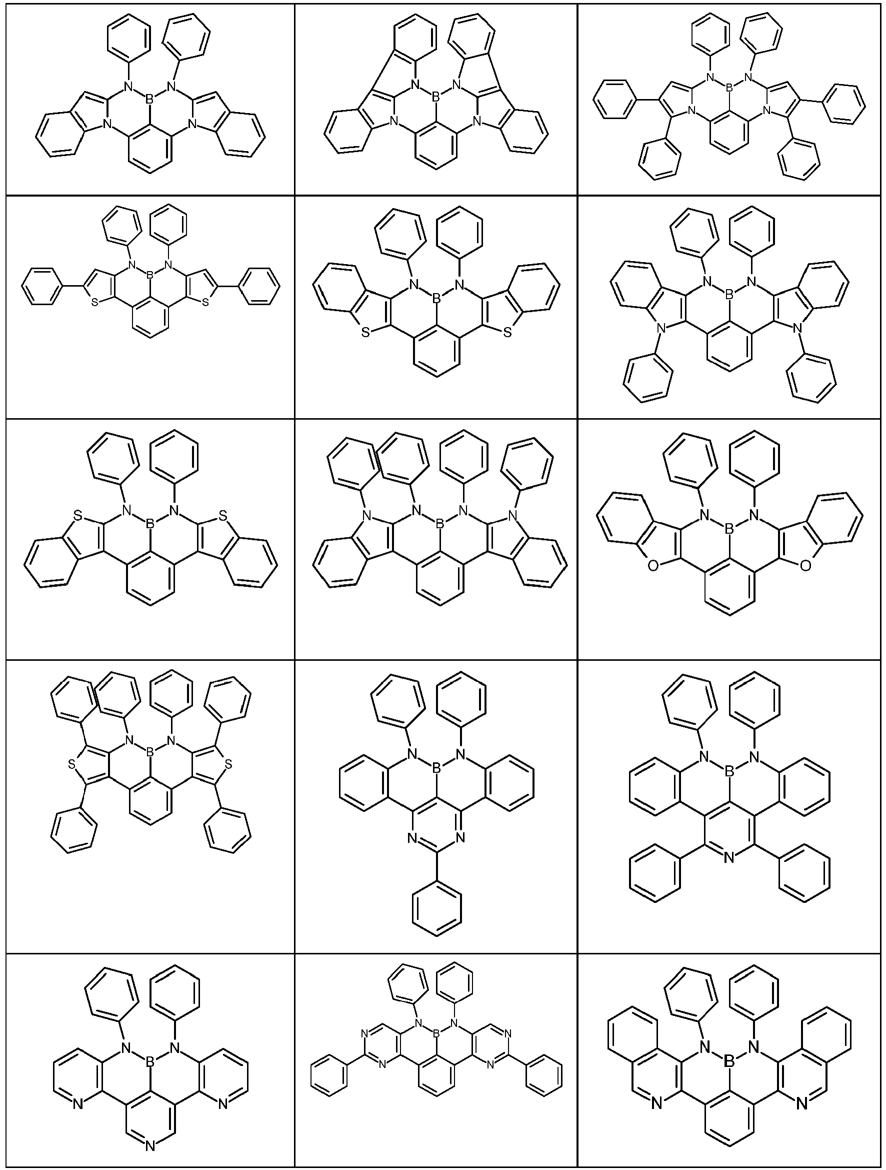

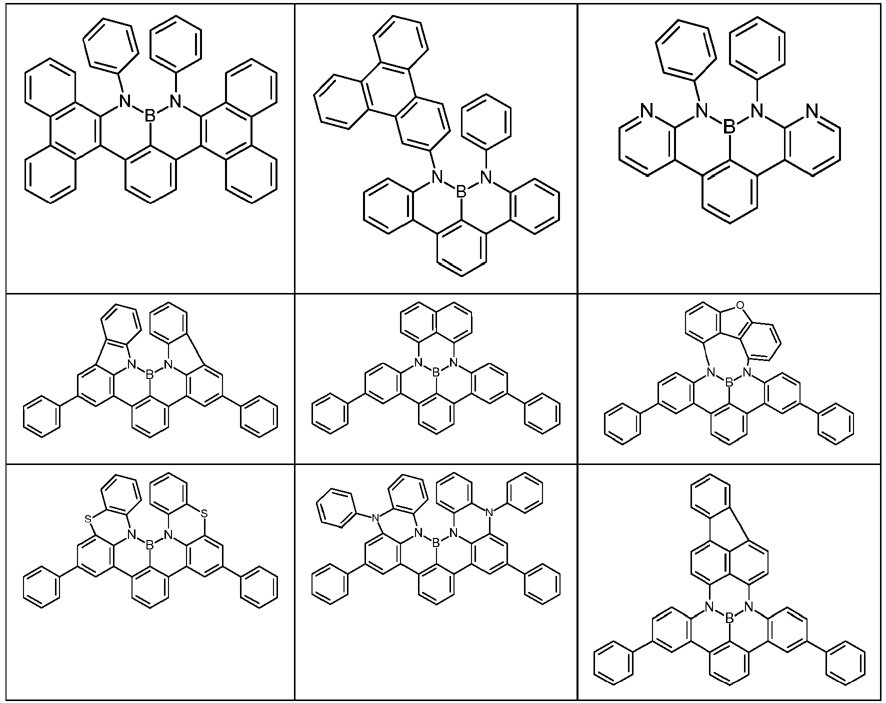

Die erfindungsgemäßen Verbindungen können nach dem Fachmann bekannten Syntheseschritten, wie z. B. Bromierung, Suzuki-Kupplung, Ullmann-Kupplung, Hartwig-Buchwald-Kupplung, etc., dargestellt werden. Ein geeignetes Syntheseverfahren ist allgemein in den folgenden Schemata 1, 2, 3 und 4 dargestellt.

Ausgehend von einem in 1,3-Position halogenierten Aromaten, z. B. 1,3-Dibrombenzol, kann der Aromat silyliert werden (Schema 1). Über eine Suzuki-Kupplung können die aromatischen Amine an den Aromaten gekuppelt werden. Die Amine können schon einfach substituiert sein. Dies kann symmetrisch (Schema 1 unten) oder in zwei Schritten (Schema 1 oben) erfolgen.

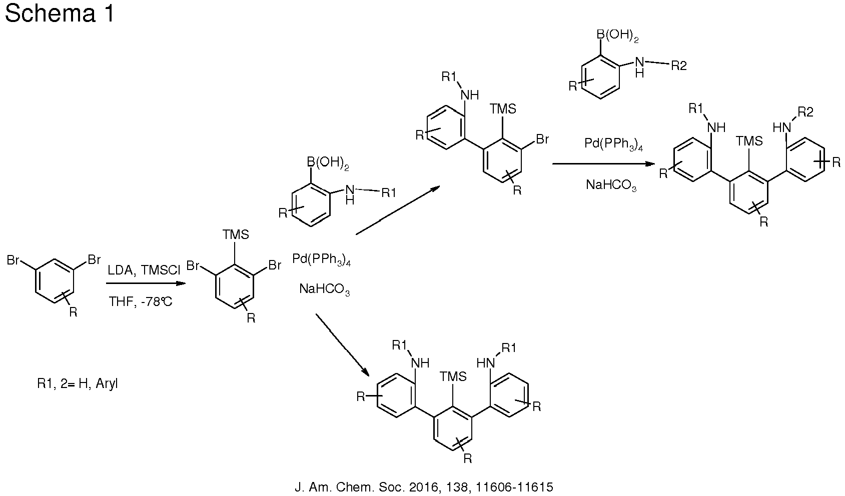

Die Silylgruppe am Aromaten kann durch Umsetzung mit Bortrichlorid gegen das Bor ausgetauscht werden (Schema 2).

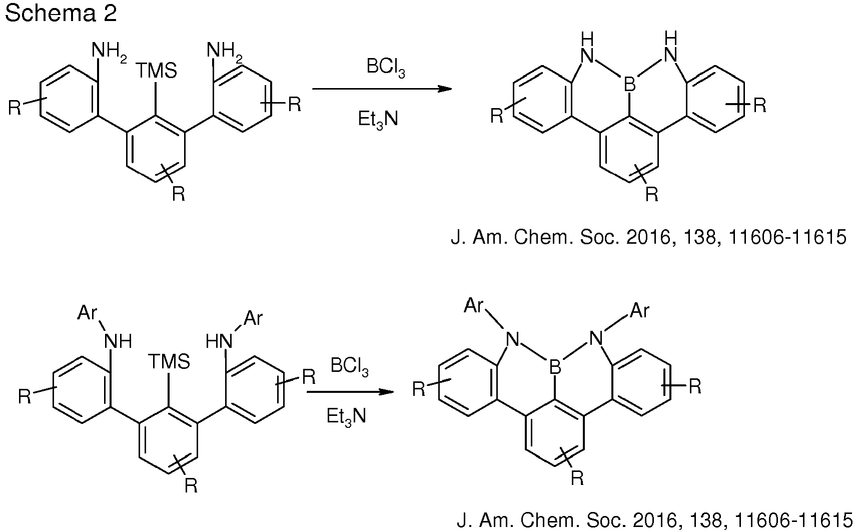

Die erhaltene Verbindung kann in weiteren Schritten funktionalisiert werden (Schemata 3 und 4). Dadurch können weitere Reste an den Aromaten eingeführt werden (Schema 3) oder die Amine weiter funktionalisiert werden (Schema 4).

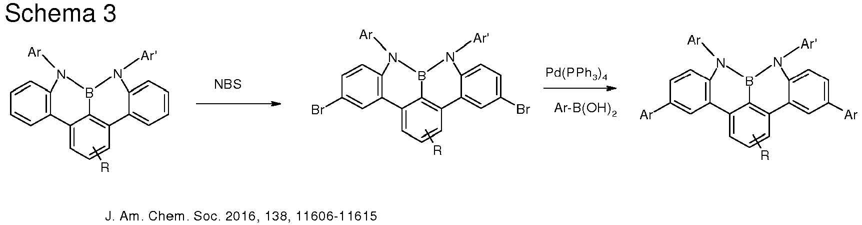

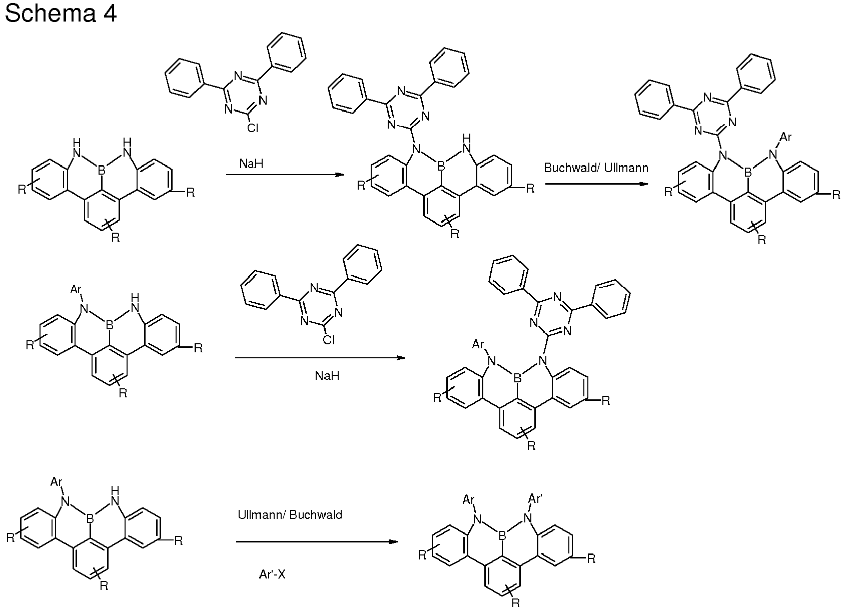

Für die Verarbeitung der erfindungsgemäßen Verbindungen aus flüssiger Phase, beispielsweise durch Spin-Coating oder durch Druckverfahren, sind Formulierungen der erfindungsgemäßen Verbindungen erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan, 2-Methylbiphenyl, 3-Methylbiphenyl, 1-Methylnaphthalin, 1-Ethylnaphthalin, Ethyloctanoat, Sebacinsäure-diethylester, Octyloctanoat, Heptylbenzol, Menthyl-isovalerat, Cyclohexylhexanoat oder Mischungen dieser Lösemittel.

Ein weiterer Gegenstand der vorliegenden Erfindung ist daher eine Formulierung, enthaltend eine erfindungsgemäße Verbindung und mindestens eine weitere Verbindung. Die weitere Verbindung kann beispielsweise ein oder mehrere Lösemittel sein, insbesondere eines der oben genannten Lösemittel oder eine Mischung dieser Lösemittel. Die weitere Verbindung kann aber auch mindestens eine weitere organische oder anorganische Verbindung sein, die ebenfalls in der elektronischen Vorrichtung eingesetzt wird, beispielsweise eine emittierende Verbindung, insbesondere ein phosphoreszierender Dotand, und/oder ein weiteres Matrixmaterial. Geeignete emittierende Verbindungen und weitere Matrixmaterialien sind hinten im Zusammenhang mit der organischen Elektrolumineszenzvorrichtung aufgeführt. Diese weitere Verbindung kann auch polymer sein.

Die erfindungsgemäßen Verbindungen und Mischungen eignen sich für die Verwendung in einer elektronischen Vorrichtung. Dabei wird unter einer elektronischen Vorrichtung eine Vorrichtung verstanden, welche mindestens eine Schicht enthält, die mindestens eine organische Verbindung enthält. Das Bauteil kann dabei aber auch anorganische Materialien enthalten oder auch Schichten, welche vollständig aus anorganischen Materialien aufgebaut sind.

Ein weiterer Gegenstand der vorliegenden Erfindung ist daher die Verwendung der erfindungsgemäßen Verbindungen oder Mischungen in einer elektronischen Vorrichtung, insbesondere in einer organischen Elektrolumineszenzvorrichtung.

Nochmals ein weiterer Gegenstand der vorliegenden Erfindung ist eine elektronische Vorrichtung enthaltend mindestens eine der oben ausgeführten erfindungsgemäßen Verbindungen oder Mischungen. Dabei gelten die oben für die Verbindung ausgeführten Bevorzugungen auch für die elektronischen Vorrichtungen.

Die elektronische Vorrichtung ist bevorzugt ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen farbstoff-sensibilisierten Solarzellen, organischen optischen Detektoren, organischen Photorezeptoren, organischen Feld-Quench-Devices (O-FQDs), lichtemittierenden elektrochemischen Zellen (LECs), organischen Laserdioden (O-Laser) und "organic plasmon emitting devices", bevorzugt organischen Elektrolumineszenzvorrichtungen (OLEDs, PLEDs), insbesondere phosphoreszierenden OLEDs.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten und/oder Ladungserzeugungsschichten (Charge-Generation Layers). Ebenso können zwischen zwei emittierende Schichten Zwischenschichten (Interlayer) eingebracht sein, welche beispielsweise eine exzitonenblockierende Funktion aufweisen. Es sei aber darauf hingewiesen, dass nicht notwendigerweise jede dieser Schichten vorhanden sein muss. Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Systeme mit drei emittierenden Schichten, wobei die drei Schichten blaue, grüne und orange oder rote Emission zeigen (für den prinzipiellen Aufbau siehe z. B. WO 2005/011013). Weiterhin bevorzugt sind Tandem-OLEDS. Es kann sich dabei um fluoreszierende oder um phosphoreszierende Emissionsschichten handeln oder um Hybrid-Systeme, bei denen fluoreszierende und phosphoreszierende Emissionsschichten miteinander kombiniert werden. Eine weiß emittierende Elektrolumineszenzvorrichtung kann beispielsweise für Beleuchtungsanwendungen, aber auch in Kombination mit einem Farbfilter für Vollfarb-Displays verwendet werden.

Die erfindungsgemäße Verbindung gemäß den oben aufgeführten Ausführungsformen kann dabei in unterschiedlichen Schichten eingesetzt werden, je nach genauer Struktur. Bevorzugt ist eine organische Elektrolumineszenzvorrichtung, enthaltend eine Verbindung gemäß Formel (1) oder gemäß den bevorzugten Ausführungsformen als Matrixmaterial für fluoreszierende oder phosphoreszierende Emitter oder für Emitter, die TADF (thermally activated delayed fluorescence) zeigen, insbesondere für phosphoreszierende Emitter, und/oder in einer Elektronentransportschicht und/oder in einer elektronenblockierenden bzw. exzitonenblockierenden Schicht und/oder in einer Lochtransportschicht und/oder Lochinjektionsschicht, je nach genauer Substitution. Dabei gelten die oben aufgeführten bevorzugten Ausführungsformen auch für die Verwendung der Materialien in organischen elektronischen Vorrichtungen.

In einer bevorzugten Ausführungsform der Erfindung wird die Verbindung gemäß Formel (1) bzw. gemäß den bevorzugten Ausführungsformen als Matrixmaterial für eine fluoreszierende oder phosphoreszierende Verbindung oder eine Verbindung, die TADF zeigt, insbesondere für eine phosphoreszierende Verbindung, in einer emittierenden Schicht eingesetzt. Dabei kann die organische Elektrolumineszenzvorrichtung eine emittierende Schicht enthalten, oder sie kann mehrere emittierende Schichten enthalten, wobei mindestens eine emittierende Schicht mindestens eine erfindungsgemäße Verbindung als Matrixmaterial enthält.

Wenn die Verbindung gemäß Formel (1) bzw. gemäß den bevorzugten Ausführungsformen als Matrixmaterial für eine emittierende Verbindung in einer emittierenden Schicht eingesetzt wird, wird sie bevorzugt in Kombination mit einem oder mehreren phosphoreszierenden Materialien (Triplettemitter) eingesetzt. Unter Phosphoreszenz im Sinne dieser Erfindung wird die Lumineszenz aus einem angeregten Zustand mit Spinmultiplizität > 1 verstanden, insbesondere aus einem angeregten Triplettzustand. Im Sinne dieser Anmeldung sollen alle lumineszierenden Übergangsmetallkomplexe und lumineszierenden Lanthanidkomplexe, insbesondere alle Iridium-, Platin- und Kupferkomplexe, als phosphoreszierende Verbindungen angesehen werden.

Die Mischung aus der Verbindung gemäß Formel (1) bzw. gemäß den bevorzugten Ausführungsformen und der emittierenden Verbindung enthält zwischen 99 und 1 Vol.-%, vorzugsweise zwischen 98 und 10 Vol.-%, besonders bevorzugt zwischen 97 und 60 Vol.-%, insbesondere zwischen 95 und 80 Vol.-% der Verbindung gemäß Formel (1) bzw. gemäß den bevorzugten Ausführungsformen bezogen auf die Gesamtmischung aus Emitter und Matrixmaterial. Entsprechend enthält die Mischung zwischen 1 und 99 Vol.-%, vorzugsweise zwischen 2 und 90 Vol.-%, besonders bevorzugt zwischen 3 und 40 Vol.-%, insbesondere zwischen 5 und 20 Vol.-% des Emitters bezogen auf die Gesamtmischung aus Emitter und Matrixmaterial. Werden die Verbindungen aus Lösung verarbeitet, so werden statt der oben angegebenen Mengen in Vol.-% bevorzugt die entsprechenden Mengen in Gew.-% verwendet.

Als phosphoreszierende Verbindungen (= Triplettemitter) eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten, insbesondere ein Metall mit dieser Ordnungszahl. Bevorzugt werden als Phosphoreszenzemitter Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium oder Platin enthalten. Im Sinne der vorliegenden Erfindung werden alle lumineszierenden Verbindungen, die die oben genannten Metalle enthalten, als phosphoreszierende Verbindungen angesehen.

Beispiele der oben beschriebenen Emitter können den Anmeldungen WO 00/70655, WO 2001/41512, WO 2002/02714, WO 2002/15645, EP 1191613, EP 1191612, EP 1191614, WO 05/033244, WO 05/019373, US 2005/0258742, WO 2009/146770, WO 2010/015307, WO 2010/031485, WO 2010/054731, WO 2010/054728, WO 2010/086089, WO 2010/099852, WO 2010/102709, WO 2011/032626, WO 2011/066898, WO 2011/157339, WO 2012/007086, WO 2014/008982, WO 2014/023377, WO 2014/094962, WO 2014/094961, WO 2014/094960, WO 2015/036074, WO 2015/104045, WO 2015/117718, WO 2016/015815, WO 2016/124304, WO 2017/032439 und der noch nicht offen gelegten Anmeldung EP 16179378.1 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind, und der Fachmann kann ohne erfinderisches Zutun weitere phosphoreszierende Komplexe verwenden.

Eine weitere bevorzugte Ausführungsform der vorliegenden Erfindung ist der Einsatz der Verbindung gemäß Formel (1) bzw. gemäß den bevorzugten Ausführungsformen als Matrixmaterial für einen phosphoreszierenden Emitter in Kombination mit einem weiteren Matrixmaterial. In einer bevorzugten Ausführungsform der Erfindung ist das weitere Matrixmaterial eine lochtransportierende Verbindung. In einer weiteren bevorzugten Ausführungsform der Erfindung ist das weitere Matrixmaterial eine elektronentransportierende Verbindung. In nochmals einer weiteren bevorzugten Ausführungsform ist das weitere Matrixmaterial eine Verbindung mit großem Bandabstand, das nicht oder nicht in wesentlichem Umfang am Loch- und Elektronentransport in der Schicht beteiligt ist.

Geeignete Matrixmaterialien, welche in Kombination mit den Verbindungen gemäß Formel (1) bzw. gemäß den bevorzugten Ausführungsformen eingesetzt werden können, sind aromatische Ketone, aromatische Phosphinoxide oder aromatische Sulfoxide oder Sulfone, z. B. gemäß WO 2004/013080, WO 2004/093207, WO 2006/005627 oder WO 2010/006680, Triarylamine, insbesondere Monoamine, z. B. gemäß WO 2014/015935, Carbazolderivate, z. B. CBP (N,N-Biscarbazolylbiphenyl) oder die in WO 2005/039246, US 2005/0069729, JP 2004/288381, EP 1205527 oder WO 2008/086851 offenbarten Carbazolderivate, Indolocarbazolderivate, z. B. gemäß WO 2007/063754 oder WO 2008/056746, Indenocarbazolderivate, z. B. gemäß WO 2010/136109 und WO 2011/000455, Azacarbazolderivate, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Triazinderivate, z. B. gemäß WO 2010/015306, WO 2007/063754 oder WO 2008/056746, Zinkkomplexe, z. B. gemäß EP 652273 oder WO 2009/062578, Diazasilol-bzw. Tetraazasilol-Derivate, z. B. gemäß WO 2010/054729, Diazaphosphol-Derivate, z. B. gemäß WO 2010/054730, überbrückte CarbazolDerivate, z. B. gemäß US 2009/0136779, WO 2010/050778, WO 2011/042107, WO 2011/088877 oder WO 2012/143080, Triphenylenderivate, z. B. gemäß WO 2012/048781, Lactame, z. B. gemäß WO 2011/116865, WO 2011/137951 oder WO 2013/064206, oder 4-Spirocarbazol-Derivate, z. B. gemäß WO 2014/094963 oder WO 2015/192939. Ebenso kann ein weiterer phosphoreszierender Emitter, welcher kürzerwellig als der eigentliche Emitter emittiert, als Co-Host in der Mischung vorhanden sein.

Bevorzugte Co-Host-Materialien sind Triarylaminderivate, insbesondere Monoamine, Indenocarbazolderivate, 4-Spirocarbazolderivate, Lactame und Carbazolderivate, wobei eine bevorzugte Ausführungsform von Carbazolderivaten Biscarbazolderivate, insbesondere 3,3'-verknüpfte Biscarbazolderivate, sind.

In einer weiteren Ausführungsform der Erfindung enthält die erfindungsgemäße organische Elektrolumineszenzvorrichtung keine separate Lochinjektionsschicht und/oder Lochtransportschicht und/oder Lochblockierschicht und/oder Elektronentransportschicht, d. h. die emittierende Schicht grenzt direkt an die Lochinjektionschicht oder die Anode an, und/oder die emittierende Schicht grenzt direkt an die Elektronentransportschicht oder die Elektroneninjektionsschicht oder die Kathode an, wie zum Beispiel in WO 2005/053051 beschrieben. Weiterhin ist es möglich, einen Metallkomplex, der gleich oder ähnlich dem Metallkomplex in der emittierenden Schicht ist, direkt angrenzend an die emittierende Schicht als Lochtransport- bzw. Lochinjektionsmaterial zu verwenden, wie z. B. in WO 2009/030981 beschrieben.

Weiterhin ist es möglich, die erfindungsgemäßen Verbindungen in einer Lochtransportschicht oder einer Elektronentransportschicht einzusetzen. Dies hängt von der jeweiligen Substitution der Verbindung ab.

In den weiteren Schichten der erfindungsgemäßen organischen Elektrolumineszenzvorrichtung können alle Materialien verwendet werden, wie sie üblicherweise gemäß dem Stand der Technik eingesetzt werden. Der Fachmann kann daher ohne erfinderisches Zutun alle für organische Elektrolumineszenzvorrichtungen bekannten Materialien in Kombination mit den erfindungsgemäßen Verbindungen gemäß Formel (1) bzw. gemäß den bevorzugten Ausführungsformen, verwenden.

Weiterhin bevorzugt ist eine organische Elektrolumineszenzvorrichtung, dadurch gekennzeichnet, dass eine oder mehrere Schichten mit einem Sublimationsverfahren aufgebracht werden. Dabei werden die Materialien in Vakuum-Sublimationsanlagen bei einem Anfangsdruck kleiner 10⁻⁵ mbar, bevorzugt kleiner 10⁻⁶ mbar aufgedampft. Es ist aber auch möglich, dass der Anfangsdruck noch geringer oder höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation aufgebracht werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden.

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Ink-Jet Druck (Tintenstrahldruck), LITI (Light Induced Thermal Imaging, Thermotransferdruck), Siebdruck, Flexodruck, Offsetdruck oder Nozzle-Printing hergestellt werden. Hierfür sind lösliche Verbindungen nötig, welche beispielsweise durch geeignete Substitution erhalten werden.

Die erfindungsgemäßen Verbindungen weisen eine verbesserte Oxidationsstabilität insbesondere in Lösung auf, insbesondere gegenüber üblicherweise verwendeten Diaminen. Dies ist insbesondere für Druckverfahren von Bedeutung. Die erfindungsgemäßen Verbindungen zeichnen sich außerdem durch eine hohe Temperaturstabilität aus, so dass sie im Hochvakuum unzersetzt verdampft werden können. Die Temperaturstabilität erhöht auch die operative Lebensdauer der Verbindungen.

Weiterhin sind Hybridverfahren möglich, bei denen beispielsweise eine oder mehrere Schichten aus Lösung aufgebracht werden und eine oder mehrere weitere Schichten aufgedampft werden. So ist es beispielsweise möglich, die emittierende Schicht aus Lösung aufzubringen und die Elektronentransportschicht aufzudampfen.

Diese Verfahren sind dem Fachmann generell bekannt und können von ihm ohne erfinderisches Zutun auf organische Elektrolumineszenzvorrichtungen enthaltend die erfindungsgemäßen Verbindungen angewandt werden.

Die erfindungsgemäßen Verbindungen weisen bei Verwendung in organischen Elektrolumineszenzvorrichtungen generell sehr gute Eigenschaften auf. Insbesondere ist bei Verwendung der erfindungsgemäßen Verbindungen in organischen Elektrolumineszenzvorrichtungen die Lebensdauer besser im Vergleich zu ähnlichen Verbindungen gemäß dem Stand der Technik. Dabei sind die weiteren Eigenschaften der organischen Elektrolumineszenzvorrichtung, insbesondere die Effizienz und die Spannung, ebenfalls besser oder zumindest vergleichbar.

Die Erfindung wird nun durch die nachfolgenden Beispiele näher erläutert, ohne sie dadurch einschränken zu wollen.

### Beispiele

Die nachfolgenden Synthesen werden, sofern nicht anders angegeben, unter einer Schutzgasatmosphäre in getrockneten Lösungsmitteln durchgeführt. Die Lösungsmittel und Reagenzien können z. B. von Sigma-ALDRICH bzw. ABCR bezogen werden. Zu den literaturbekannten Verbindungen sind jeweils auch die entsprechenden CAS-Nummern angegeben.

### Synthesebeispiele

### a) Phenyl-[2-(4,4,5,5-tetramethyl-[1,3,2]dioxaborolan-2-yl)-phenyl]-amin

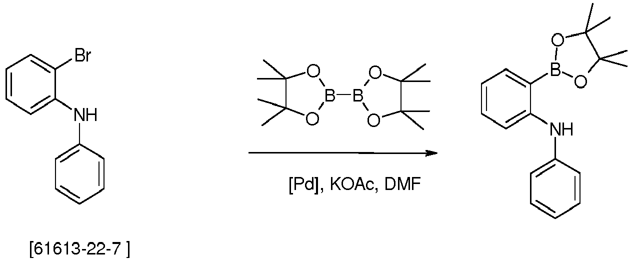

In einem 500 ml-Kolben werden unter Schutzgas 7 g (28 mmol, 35%) 2-Bromphenyl-phenyl-amin und 8,6 g (35 mmol, 1,2 eq) Bis(pinacolato)-diboran (CAS 73183-34-3) in 120 ml trockenem DMF gelöst und für 30 Minuten entgast. Anschließend werden 8,2 g (84 mmol, 3,0 eq) Kaliumacetat und 690 mg (0,84 mmol, 3 mol-%) [1,1'-Bis(diphenylphosphino)-ferrocen]-dichlorpalladium(II)-Komplex mit Dichlormethan (CAS 95464-05-4) zugegeben und der Ansatz über Nacht auf 90 °C er hitzt. Nach beendeter Reaktion wird mit 300 ml Toluol verdünnt und das Gemisch mit Wasser extrahiert. Das Lösungsmittel wird am Rotationsverdampfer entfernt und der erhaltene Feststoff getrocknet. Das Produkt (6,6 g, 22 mmol, 80% der Theorie) wird ohne weitere Aufreinigung umgesetzt.

Analog können folgende Verbindungen erhalten werden:

| **Nr.** | **Edukt** | **Produkt** | **Ausbeute** |
|---|---|---|---|
| **1a** | 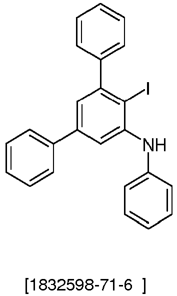 | 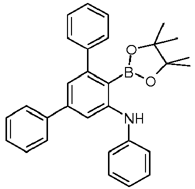 | 76% |
| **2a** | 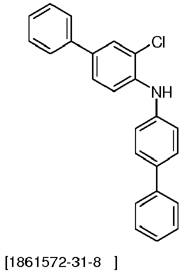 | 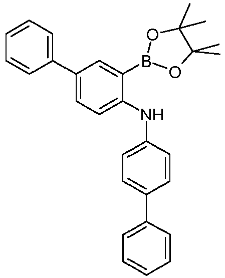 | 78% |
| **3a** | 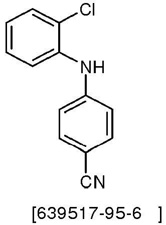 | 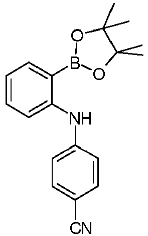 | 82% |
| **4a** | 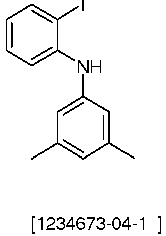 | 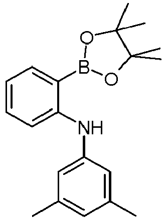 | 81% |
| **5a** | 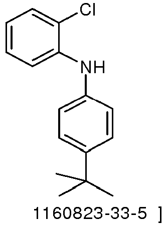 | 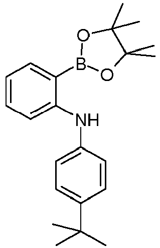 | 83% |
| **6a** | 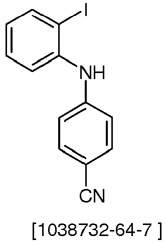 | 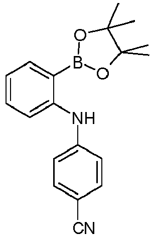 | 76% |
| **7a** | 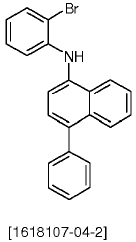 | 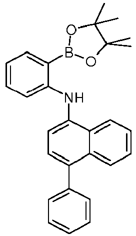 | 78% |
| **8a** | 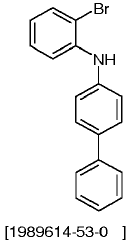 | 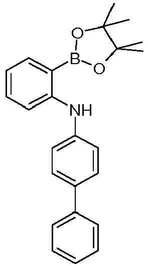 | 88% |
| **9a** | 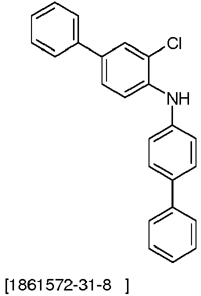 | 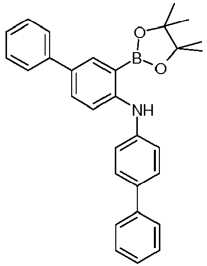 | 65% |
| **10a** | 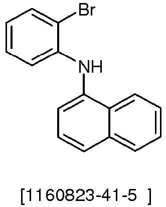 | 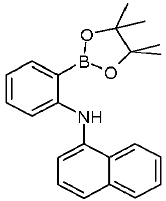 | 76% |
| **11a** | 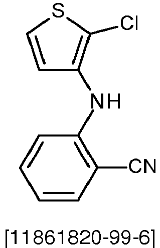 | 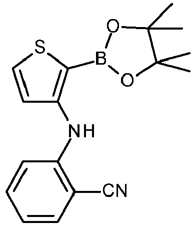 | 75% |
| **12a** | 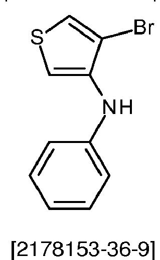 | 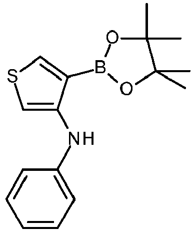 | 62% |
| **13a** | 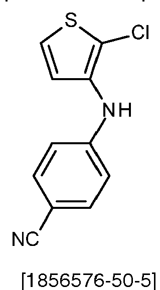 | 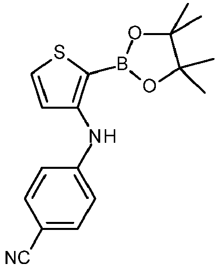 | 66% |
| **14a** | 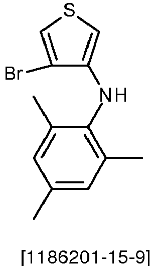 | 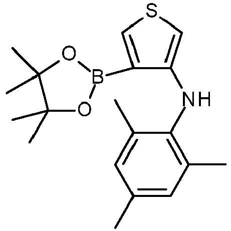 | 58% |

### b) N2,N2"-Diphenyl-2'-trimethylsilanyl-[1,1';3',1"]terphenyl-2,2"-diamin

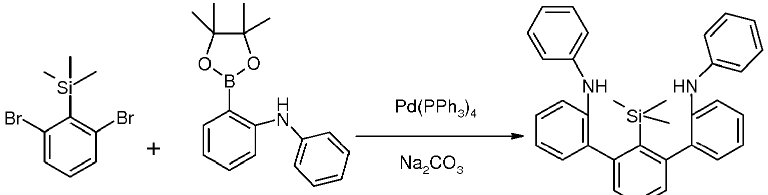

20,5 g (70 mmol) N-Phenyl-2-(4',4',5',5'-tetramethyl-1',3',2'-dioxaborolan-2-yl)-phenylamin, 21,5 g (70 mmol) (2,6-Dibromphenyl)-trimethylsilan und 78,9 mL (158 mmol) Na₂CO₃ (2 M-Lösung) werden in 200 ml Dimethoxyethan suspendiert. Zu dieser Suspension werden 1,3 g (1,1 mmol) Pd(PPh₃)₄ gegeben, und die Reaktionsmischung wird 16 h unter Rückfluss erhitzt. Nach Erkalten wird die Mischung mit Dichloromethan versetzt, die organische Phase abgetrennt, über Kieselgel filtriert und aus Toluol umkristallisiert. Die Ausbeute beträgt 21,6 g (45 mmol), entsprechend 85% der Theorie.

Analog können folgende Verbindungen erhalten werden:

| **Nr.** | **Edukt 1** | **Edukt 2** | **Produkt** | **Ausbeute** |
|---|---|---|---|---|
| **1b** | 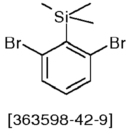 | 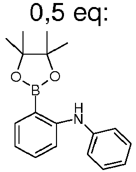 | 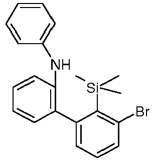 | 61% |
| **2b** | 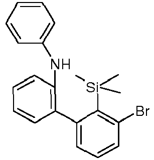 | 0,5 eq: | 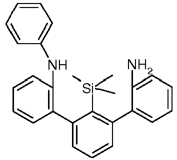 | 70% |
| | | 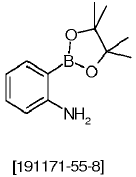 | | |
| **3b** | 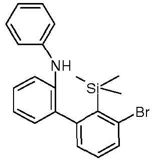 | 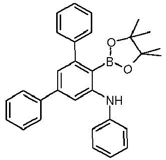 | 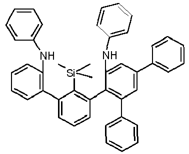 | 80% |
| **4b** | 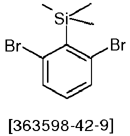 | 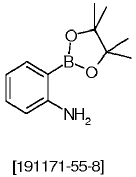 | 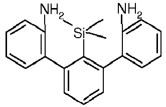 | 86% |
| **5b** | 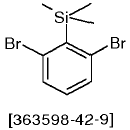 | 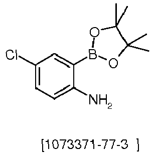 | 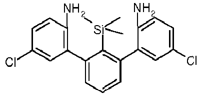 | 79% |
| **6b** | 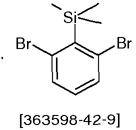 | 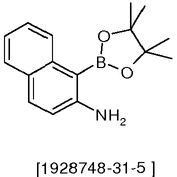 | 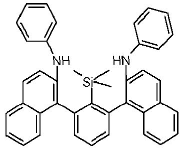 | 75% |
| **7b** | 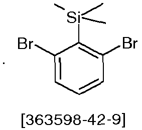 | 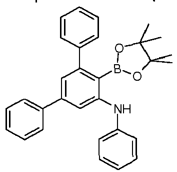 | 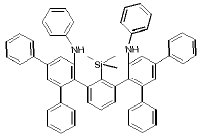 | 70% |
| **8b** | 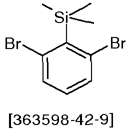 | 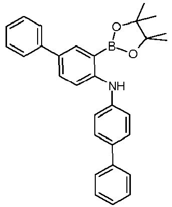 | 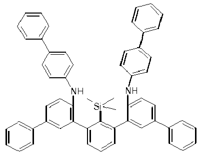 | 74% |
| **9b** | 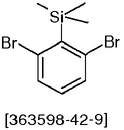 | 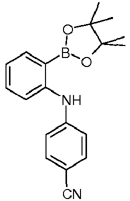 | 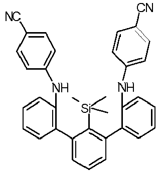 | 72% |
| **10b** | 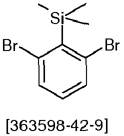 | 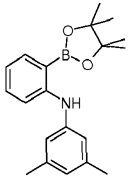 | 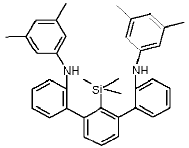 | 76% |
| **11b** | 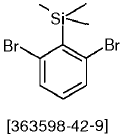 | 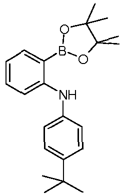 | 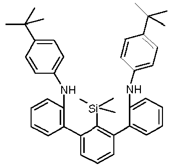 | 69% |
| **12b** | 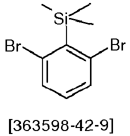 | 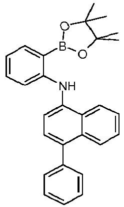 | 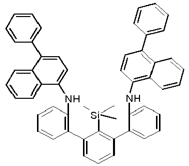 | 65% |
| **13b** | 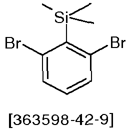 | 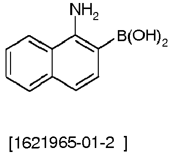 | 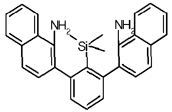 | 80% |
| **14b** | 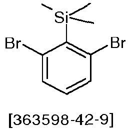 | 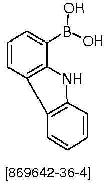 | 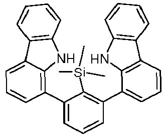 | 61% |
| **15b** | 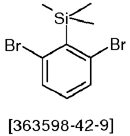 | 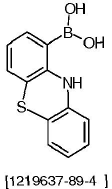 | 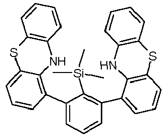 | 64% |
| **16b** | 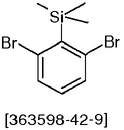 | 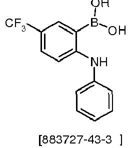 | 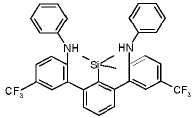 | 82% |
| **17b** | 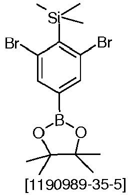 | 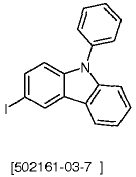 | 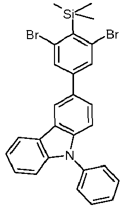 | 63% |
| **18b** | 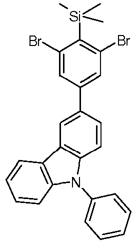 | 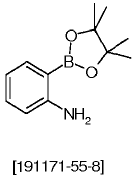 | 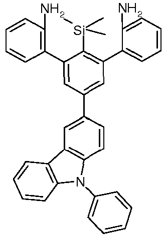 | 79% |
| **19b** | 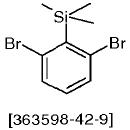 | 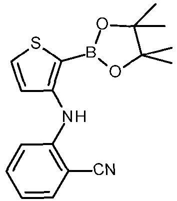 | 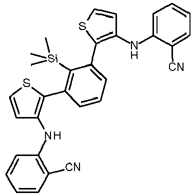 | 73% |
| **20b** | 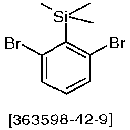 | 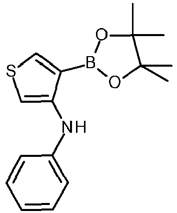 | 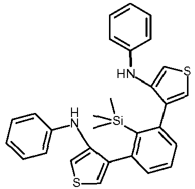 | 70% |
| **21b** | 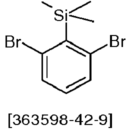 | 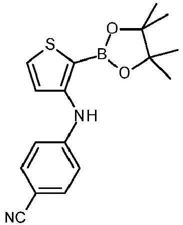 | 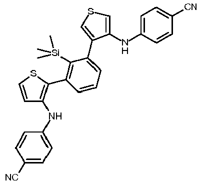 | 74% |
| **22b** | 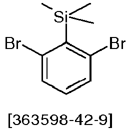 | 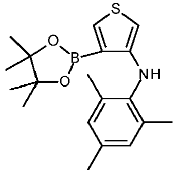 | 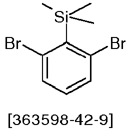 | 64% |
| **23b** | 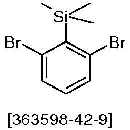 | 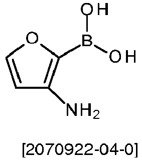 | 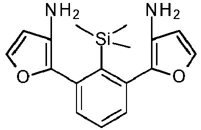 | 64% |
| **24b** | 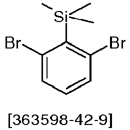 | 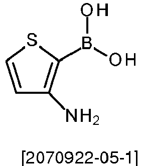 | 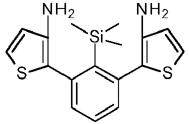 | 67% |

### c) 8,9-Diphenyl-8H,9H-8,9-diaza-8a-bora-benzo[fg]naphthacen

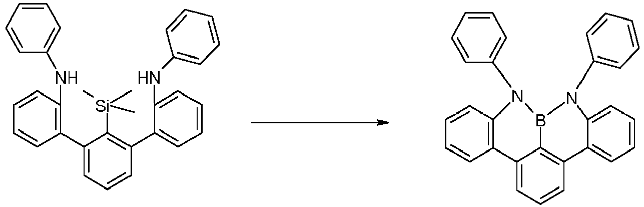

Unter Schutzgas werden 9,6 g (20 mmol) N2,N2"-Diphenyl-2'-trimethyl-silanyl-[1,1';3',1"]terphenyl-2,2"-diamin in 400 ml o-Dichlorbenzol gelöst. Zu dieser Lösung werden 6 g (60 mmol) Triethylamin und 300 ml (1,5 mmol) Bortrichlorid 1 M in Hexan zugegeben, und die Reaktionsmischung wird 12 h unter Rückfluss (∼180 °C) erhitzt. Nach Erkalten wird die Mischung eingeengt, chromatographisch getrennt (CH₂Cl₂/Heptan, 5:1), aus einer CH₂Cl₂/MeOH-Mischung umkristallisiert und abschließend im Hochvakuum (p = 5 x 10⁻⁵ mbar) sublimiert. Die Ausbeute beträgt 7,2 g (17 mmol), entsprechend 87% der Theorie.

Analog können folgende Verbindungen erhalten werden:

| **Nr.** | **Edukt 4** | **Produkt** | **Ausbeute** |
|---|---|---|---|
| **1c** | 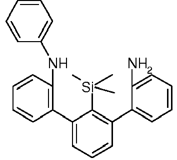 | 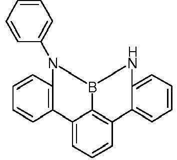 | 74% |
| **2c** | 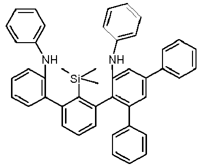 | 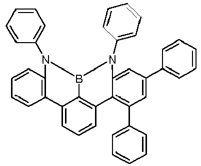 | 80% |
| **3c** | 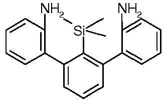 | 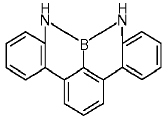 | 89% |
| **4c** | 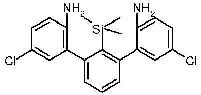 | 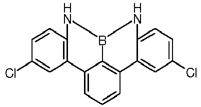 | 69% |
| **5c** | 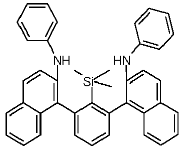 | 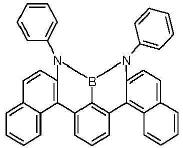 | 78% |
| **6c** | 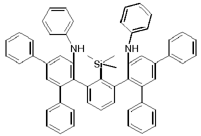 | 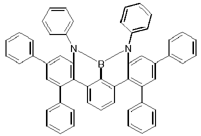 | 70% |
| **7c** | 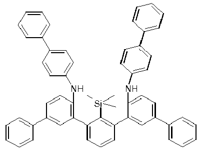 | 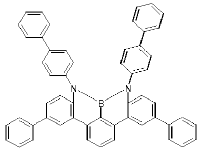 | 74% |
| **8c** | 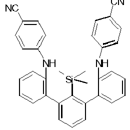 | 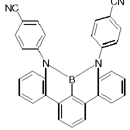 | 72% |
| **9c** | 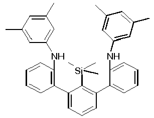 | 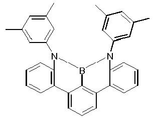 | 76% |
| **10c** | 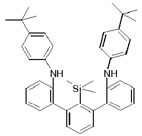 | 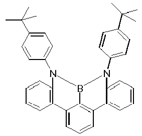 | 69% |
| **11c** | 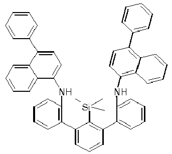 | 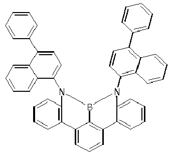 | 65% |
| **12c** | 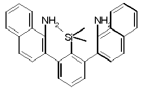 | 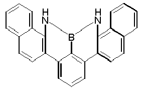 | 80% |
| **13c** | 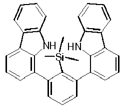 | 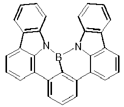 | 61% |
| **14c** | 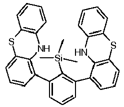 | 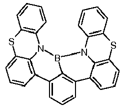 | 63% |
| **15c** | 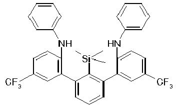 | 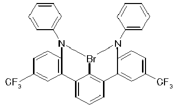 | 82% |
| **16c** | 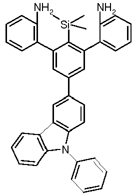 | 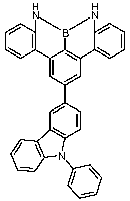 | 79% |
| **17c** | 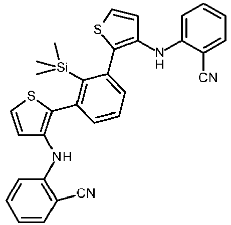 | 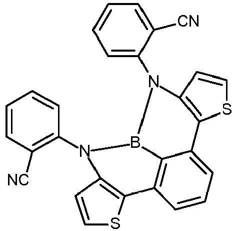 | 70% |
| **18c** | 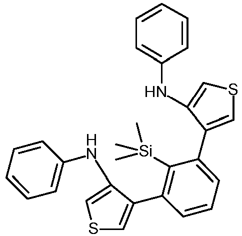 | 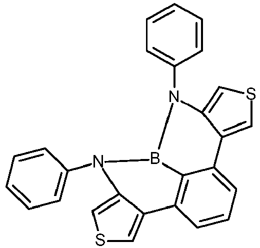 | 65% |
| **19c** | 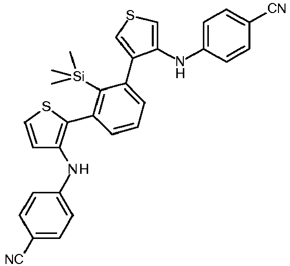 | 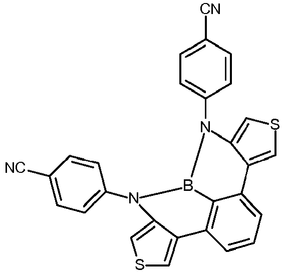 | 73% |
| **20c** | 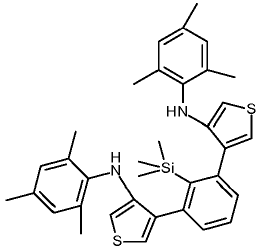 | 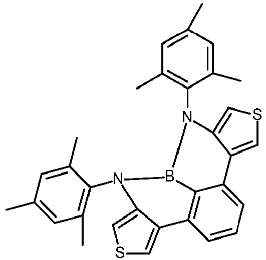 | 59% |
| **21c** | 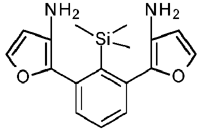 | 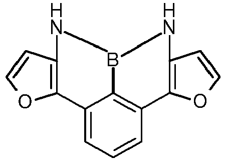 | 52% |
| **22c** | 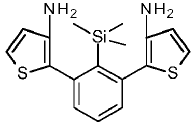 | 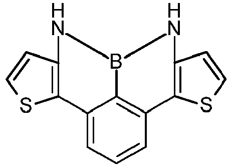 | 58% |

### d) 5,12-Dibrom-8,9-bis-(4-tert-butyl-phenyl)-8H,9H-8,9-diaza-8a-bora-benzo[fg]naphthacen

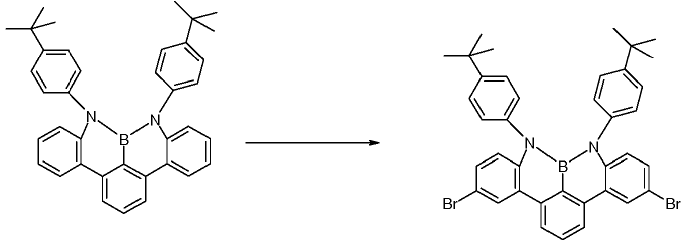

100 g (190,0 mmol) 8,9-Bis-(4-tert-butyl-phenyl)-8H,9H-8,9-diaza-8a-bora-benzo[fg]naphthacen werden in 500 mL CH₂Cl₂ und 150 ml Essigsäure gelöst. Zu dieser Suspension werden portionsweise 34 g (190 mmol) NBS zugegeben und 9 h bei Dunkelheit gerührt. Danach wird mit Wasser/Eis versetzt, der Feststoff abgetrennt und mit Ethanol nachgewaschen. Der Rückstand wird aus Toluol umkristallisiert. Die Ausbeute beträgt 98 g (142 mmol), entsprechend 76% der Theorie.

Analog können folgende Verbindungen erhalten werden:

| **Nr.** | **Edukt 4** | **Produkt** | **Ausbeute** |
|---|---|---|---|
| **1d** | 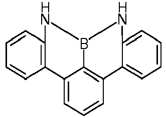 | 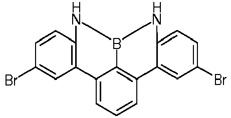 | 75% |
| **2d** | 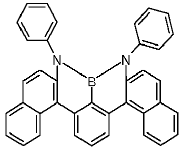 | 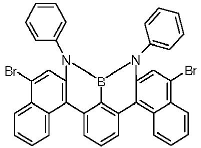 | 81% |
| **3d** | 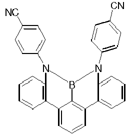 | 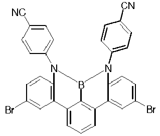 | 83% |
| **4d** | 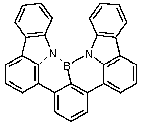 | 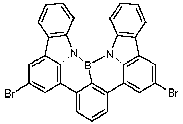 | 62% |
| **5d** | 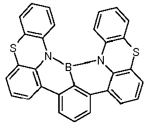 | 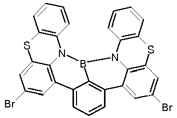 | 65% |
| **6d** | 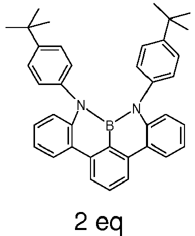 | 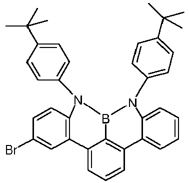 | 56% |
| **7d** | 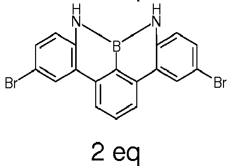 | 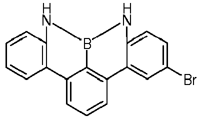 | 53% |

Analog zu Vorschrift b können folgende Verbindungen erhalten werden:

| **Nr.** | **Edukt 1** | **Edukt 2** | **Produkt** | **Ausbeute** |
|---|---|---|---|---|
| **19b** | 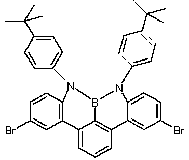 | 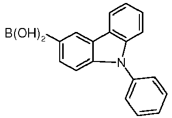 | 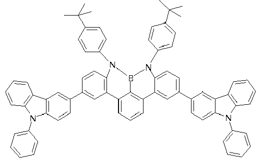 | 61% |
| **20b** | 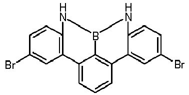 | 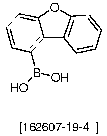 | 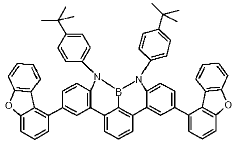 | 70% |
| **21b** | 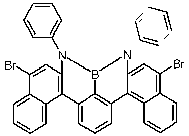 | 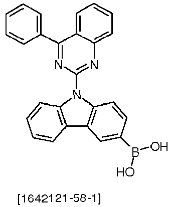 | 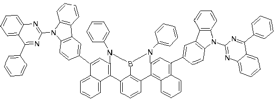 | 76% |
| **22b** | 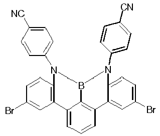 | 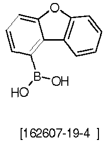 | 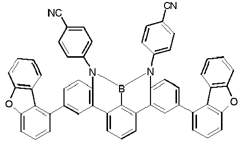 | 70% |
| **23b** | 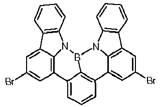 | 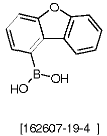 | 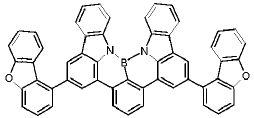 | 71% |
| **24b** | 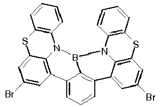 | 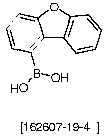 | 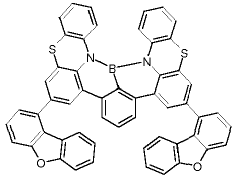 | 78% |
| **25b** | 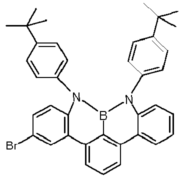 | 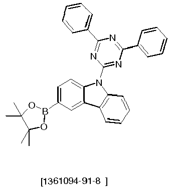 | 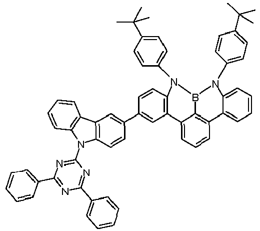 | 65% |
| **26b** | 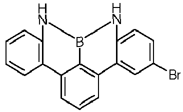 | 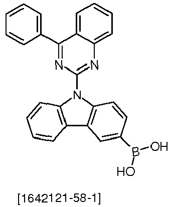 | 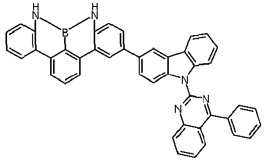 | 66% |
| **27b** | 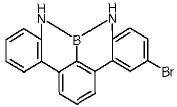 | 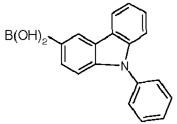 | 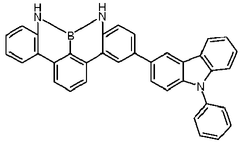 | 74% |
| **28b** | 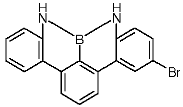 | 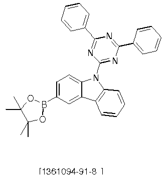 | 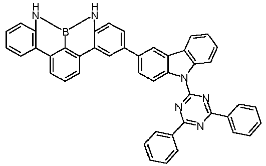 | 76% |
| **29b** | 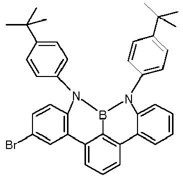 | 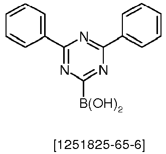 | 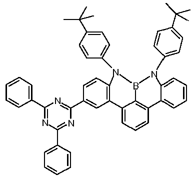 | 59% |

### e) 8-(4,6-Diphenyl-[1,3,5]triazin-2-yl)-9-phenyl-8H,9H-8,9-diaza-8a-bora-benzo[fg]naphthacen

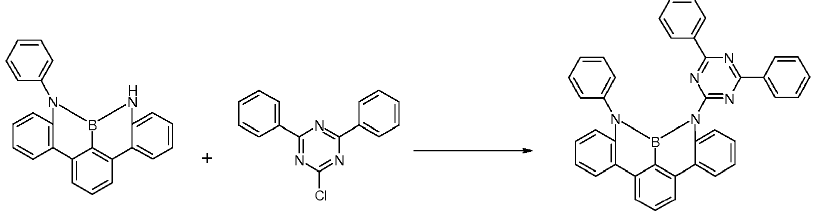

4,3 g NaH, 60%ig in Mineralöl (107 mmol) werden in 300 mL Dimethylformamid unter Schutzatmosphäre gelöst. 36 g (107 mmol) 8-Phenyl-8H,9H-8,9-diaza-8a-bora-benzo[fg]naphthacen werden in 250 mL DMF gelöst und zu der Reaktionsmischung zugetropft. Nach 1 h bei Raumtemperatur wird eine Lösung von 28,5 g (107 mmol) 2-Chlor-4,6-diphenyl-[1,3,5]triazin in 200 mL THF zugetropft. Das Reaktionsgemisch wird 12 h bei Raumtemperatur gerührt und dann auf Eis gegossen. Der dabei ausgefallene Feststoff wird nach Erwärmen auf Raumtemperatur filtriert und mit Ethanol und Heptan gewaschen. Der Rückstand wird mit Toluol heiß extrahiert, aus Toluol/n-Heptan umkristallisiert und abschließend im Hochvakuum sublimiert. Die Ausbeute beträgt 36 g (62 mmol; 60%); Reinheit 99,9%.

Analog können folgende Verbindungen erhalten werden:

| **Nr.** | **Edukt 1** | **Edukt 2** | **Produkt** | **Ausbeute** |
|---|---|---|---|---|
| **1e** | 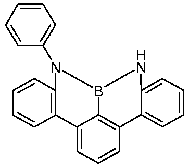 | 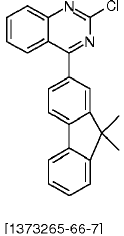 | 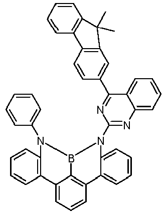 | 61% |
| **2e** | 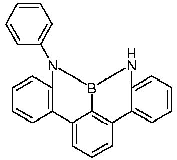 | 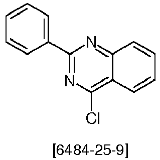 | 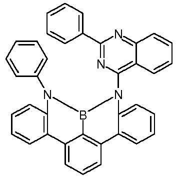 | 58% |
| **3e** | 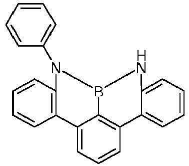 | 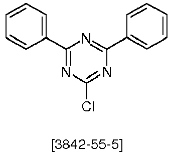 | 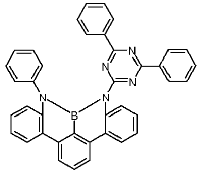 | 62% |
| **4e** | 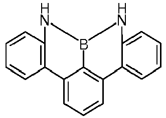 | 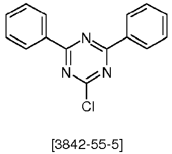 | 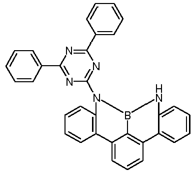 | 61% |
| **5e** | 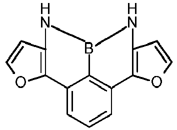 | 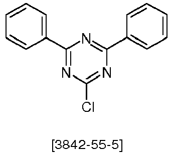 | 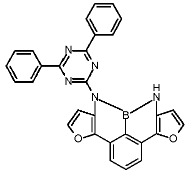 | 60% |
| **6e** | 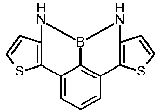 | 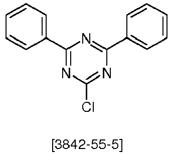 | 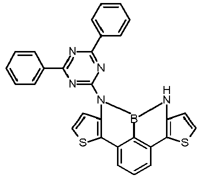 | 58% |

### f) 8-[3-(4,6-Diphenyl-[1,3,5]triazin-2-yl)-phenyl]-9-phenyl-8H,9H-8,9-diaza-8a-bora-benzo[fg]naphthacen

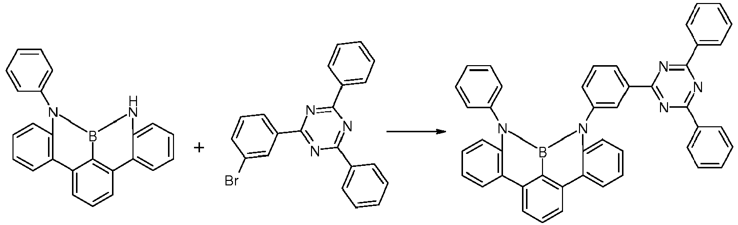

22,5 g (66 mmol) 8-Phenyl-8H,9H-8,9-diaza-8a-bora-benzo[fg]naphthacen, 28,5 g (73 mmol) 3-Brom-(4,6-diphenyl-[1,3,5]triazin-2-yl)-benzol und 19 g NaOtBu werden in 1 L p-Xylol suspendiert. Zu dieser Suspension werden 0,3 g (1,33 mmol) Pd(OAc)₂ und 1,0 ml einer 1M Tri-tert-butylphosphin-Lösung in Toluol gegeben. Die Reaktionsmischung wird 16 h unter Rückfluss erhitzt. Nach Erkalten wird mit Methylenchlorid versetzt, die organische Phase abgetrennt, dreimal mit 200 mL Wasser gewaschen und anschließend zur Trockene eingeengt. Der Rückstand wird mit Toluol heiß extrahiert, aus Toluol umkristallisiert und abschließend im Hochvakuum sublimiert. Die Reinheit beträgt 99,9%. Die Ausbeute beträgt 29 g (45 mmol; 70%).

Analog können folgende Verbindungen erhalten werden:

| **Nr.** | **Edukt 1** | **Edukt 2** | **Produkt** | **Ausbeute** |
|---|---|---|---|---|
| **1f** | 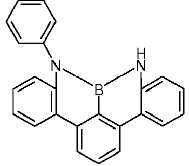 | 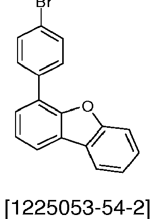 | 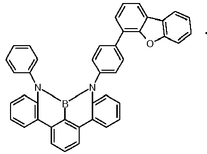 | 61% |
| **2f** | 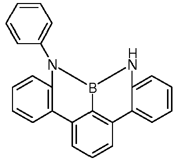 | 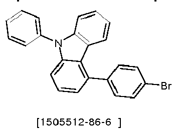 | 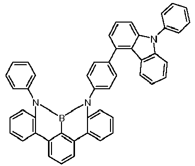 | 58% |
| **3f** | 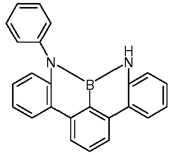 | 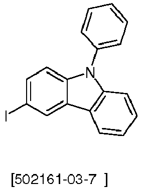 | 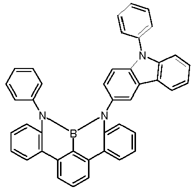 | 62% |
| **4f** | 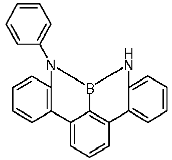 | 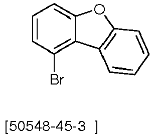 | 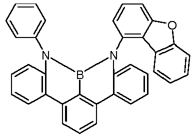 | 61% |
| **5f** | 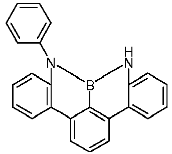 | 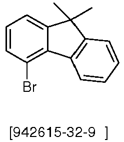 | 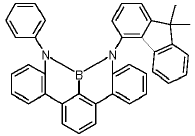 | 72% |
| **6f** | 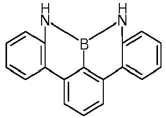 | 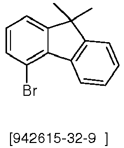 | 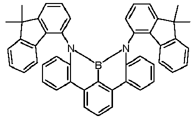 | 80% |
| **7f** | 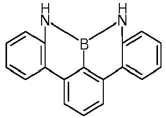 | 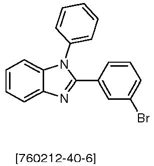 | 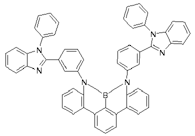 | 69% |
| **8f** | 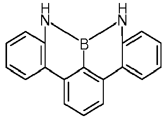 | 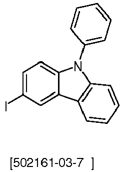 | 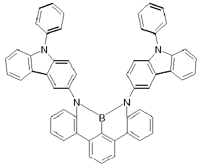 | 84% |
| **9f** | 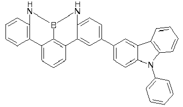 | 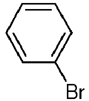 | 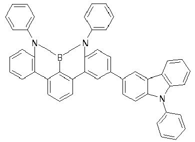 | 80% |
| **10f** | 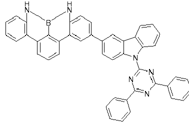 | 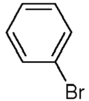 | 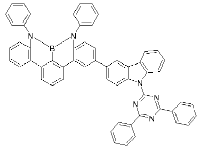 | 81% |
| **11f** | 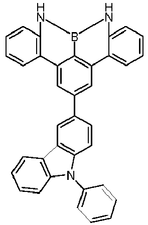 | 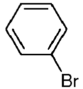 | 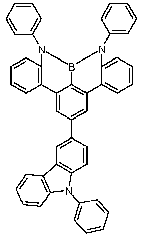 | 76% |
| **12f** | 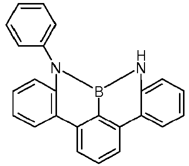 | 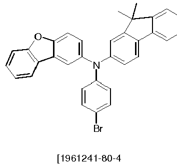 | 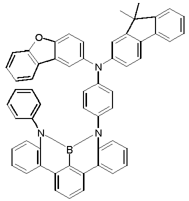 | 77% |
| **13f** | 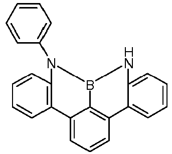 | 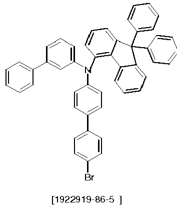 | 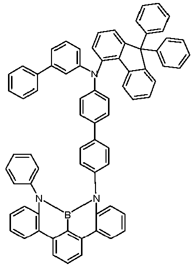 | 76% |
| **14f** | 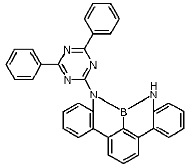 | 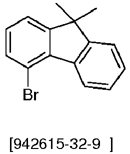 | 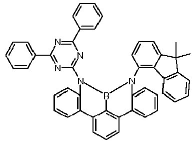 | 78% |
| **15f** | 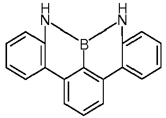 | 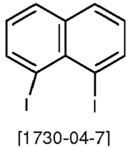 | 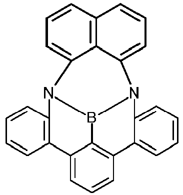 | 65% |
| **16f** | 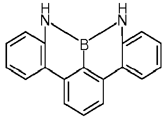 | 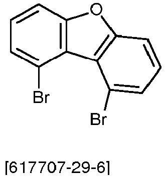 | 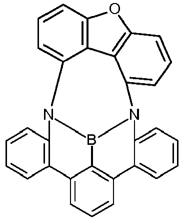 | 60% |
| **17f** | 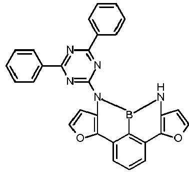 | 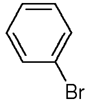 | 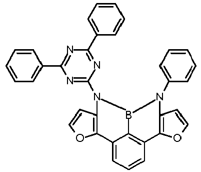 | 62% |
| **18f** | 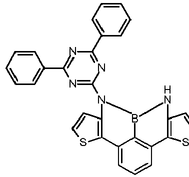 | 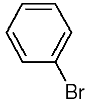 | 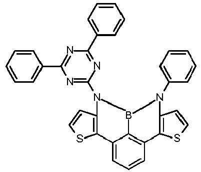 | 66% |

### Herstellung der OLEDs

In den folgenden Beispielen E1 bis E10 (siehe Tabelle 1) wird der Einsatz der erfindungsgemäßen Materialien in OLEDs vorgestellt.

**Vorbehandlung für die Beispiele E1-E10:** Glasplättchen, die mit strukturiertem ITO (Indium Zinn Oxid) der Dicke 50 nm beschichtet sind, werden vor der Beschichtung mit einem Sauerstoffplasma, gefolgt von einem Argonplasma, behandelt. Diese mit Plasma behandelten Glasplättchen bilden die Substrate, auf welche die OLEDs aufgebracht werden.

Die OLEDs haben prinzipiell folgenden Schichtaufbau: Substrat / Lochinjektionsschicht (HIL) / Lochtransportschicht (HTL) / Elektronenblockierschicht (EBL) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet. Der genaue Aufbau der OLEDs ist Tabelle 1 zu entnehmen. Die zur Herstellung der OLEDs benötigten Materialien sind in Tabelle 2 gezeigt.

Alle Materialien werden in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie EG1 :IC2:TEG1 (44%:44%:12%) bedeutet hierbei, dass das Material EG1 in einem Volumenanteil von 44%, IC2 in einem Volumenanteil von 44% und TEG1 in einem Volumenanteil von 12% in der Schicht vorliegt. Analog kann auch die Elektronentransportschicht aus einer Mischung von zwei Materialien bestehen.

Die OLEDs werden standardmäßig charakterisiert. Die Elektrolumineszenzspektren werden bei einer Leuchtdichte von 1000 cd/m² bestimmt und daraus die CIE 1931 x und y Farbkoordinaten berechnet.

### Verwendung von erfindungsgemäßen Materialien in OLEDs

Die erfindungsgemäßen Materialien können in der Emissionsschicht in phosphoreszierenden grünen OLEDs eingesetzt werden. Die erfindungsgemäßen Verbindungen EG1 bis EG10 werden in den Beispielen E1 bis E10 als Matrixmaterial in der Emissionsschicht eingesetzt. Die Farbkoordinaten der Elektrolumineszenzspektren der OLEDs aus diesen Beispielen liegen bei CIEx = 0,33 und CIEy = 0,63. Somit eignen sich die Materialien für den Einsatz in der Emissionsschicht von grünen OLEDs. Des Weiteren lassen sich die erfindungsgemäßen Materialien in der Lochblockierschicht (HBL) oder in der Elektronenblockierschicht (EBL) erfolgreich einsetzen. Dies ist in den Beispielen E11 und E12 gezeigt. Auch hier liegen die Farbkoordinaten des Spektrums der OLED bei CIEx = 0,33 und ClEy = 0,63.

**Tabelle 1: Aufbau der OLEDs**

| Bsp | HIL Dicke | HTL Dicke | EBL Dicke | EML Dicke | HBL Dicke | ETL Dicke | EIL Dicke |
|---|---|---|---|---|---|---|---|
| E1 | HATCN 5nm | SpMA1 230nm | SpMA2 20nm | EG1:IC2:TEG1 (44%:44%:12%) 30nm | ST2 10nm | ST2:LiQ (50%:50%) 30nm | LiQ 1nm |
| E2 | HATCN 5nm | SpMA1 230nm | SpMA2 20nm | EG2:IC2:TEG1 (44%:44%:12%) 30nm | ST2 10nm | ST2:LiQ (50%:50%) 30nm | LiQ 1nm |
| E3 | HATCN 5nm | SpMA1 230nm | SpMA2 20nm | EG3:IC2:TEG1 (44%:44%:12%) 30nm | ST2 10nm | ST2:LiQ (50%:50%) 30nm | LiQ 1nm |
| E4 | HATCN 5nm | SpMA1 230nm | SpMA2 20nm | EG4:IC2:TEG1 (44%:44%:12%) 30nm | ST2 10nm | ST2:LiQ (50%:50%) 30nm | LiQ 1nm |
| E5 | HATCN 5nm | SpMA1 230nm | SpMA2 20nm | EG5:IC2:TEG1 (44%:44%:12%) 30nm | ST2 10nm | ST2:LiQ (50%:50%) 30nm | LiQ 1nm |
| E6 | HATCN 5nm | SpMA1 230nm | SpMA2 20nm | EG6:IC2:TEG1 (44%:44%:12%) 30nm | ST2 10nm | ST2:LiQ (50%:50%) 30nm | LiQ 1nm |
| E7 | HATCN 5nm | SpMA1 230nm | SpMA2 20nm | EG7:IC1:TEG1 (44%:44%:12%) 30nm | ST2 10nm | ST2:LiQ (50%:50%) 30nm | LiQ 1nm |
| E8 | HATCN 5nm | SpMA1 230nm | SpMA2 20nm | EG8:IC1:TEG1 (44%:44%:12%) 30nm | ST2 10nm | ST2:LiQ (50%:50%) 30nm | LiQ 1nm |
| E9 | HATCN 5nm | SpMA1 230nm | SpMA2 20nm | EG9:IC2:TEG1 (44%:44%:12%) 30nm | ST2 10nm | ST2:LiQ (50%:50%) 30nm | LiQ 1nm |
| E10 | HATCN 5nm | SpMA1 230nm | SpMA2 20nm | IC1:IC2:TEG1 (44%:44%:12%) 30nm | ST2 10nm | ST2:LiQ (50%:50%) 30nm | LiQ 1nm |
| E11 | HATCN 5nm | SpMA1 230nm | SpMA2 20nm | IC1:IC2:TEG1 (44%:44%:12%) 30nm | EG1 10nm | ST2:LiQ (50%:50%) 30nm | LiQ 1nm |
| E12 | HATCN 5nm | SpMA1 230nm | EG8 20nm | EG9:IC2:TEG1 (44%:44%:12%) 30nm | ST2 10nm | ST2:LiQ (50%:50%) 30nm | LiQ 1nm |
| E13 | HATCN 5nm | SpMA1 230nm | EG8 20nm | EG11:IC2:TEG1 (44%:44%:12%) 30nm | ST2 10nm | ST2:LiQ (50%:50%) 30nm | LiQ 1nm |
| E14 | HATCN 5nm | SpMA1 230nm | EG8 20nm | EG12:IC2:TEG1 (44%:44%:12%) 30nm | ST2 10nm | ST2:LiQ (50%:50%) 30nm | LiQ 1nm |
| E15 | HATCN 5nm | SpMA1 230nm | EG8 20nm | EG13:IC2:TEG1 (44%:44%:12%) 30nm | ST2 10nm | ST2:LiQ (50%:50%) 30nm | LiQ 1nm |
| E15 | HATCN 5nm | SpMA1 230nm | EG8 20nm | EG14:IC2:TEG1 (44%:44%:12%) 30nm | ST2 10nm | ST2:LiQ (50%:50%) 30nm | LiQ 1nm |

**Tabelle 2: Strukturformeln der Materialien für die OLEDs**

| | |
|---|---|
| 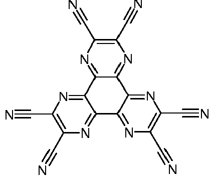 | 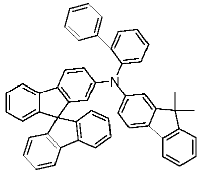 |
| HATCN | SpMA1 |
| 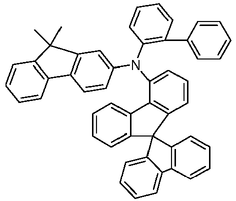 | 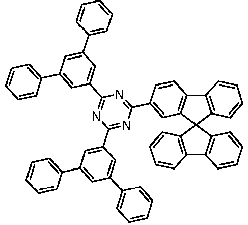 |
| SpMA2 | ST2 |
| 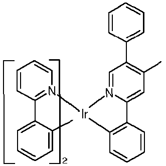 | 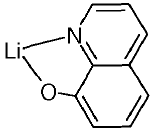 |
| TEG1 | LiQ |
| 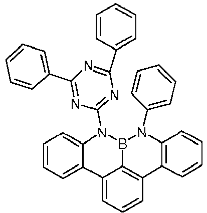 | 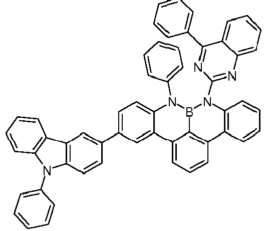 |
| EG1 | EG2 |
| 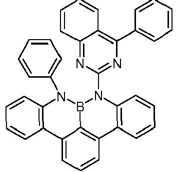 | 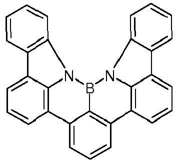 |
| EG3 | EG4 |
| 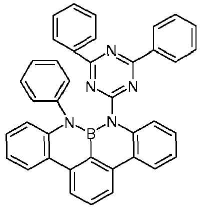 | 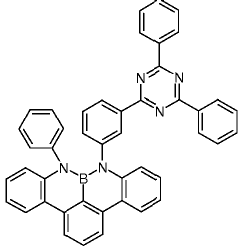 |
| EG5 | EG6 |
| 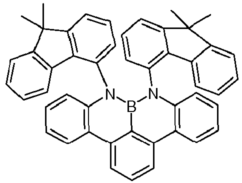 | 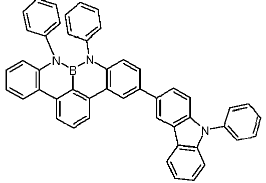 |
| EG7 | EG8 |
| 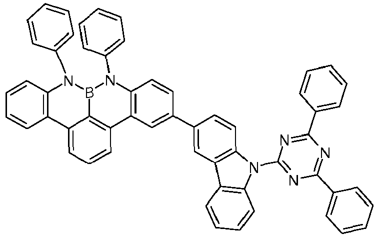 | 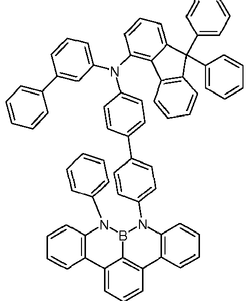 |
| EG9 | EG10 |
| 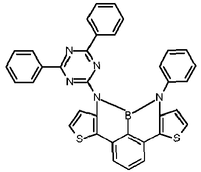 | 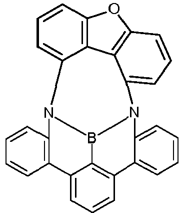 |
| EG11 | EG12 |
| 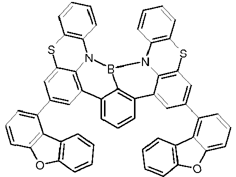 | |
| EG13 | EG14 |
| 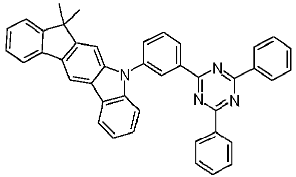 | 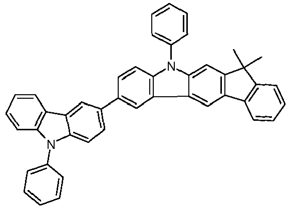 |
| IC1 | IC2 |

## Patentansprüche

1. Verbindung gemäß Formel (1), 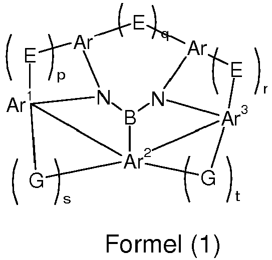 wobei für die verwendeten Symbole und Indizes gilt:
E ist bei jedem Auftreten gleich oder verschieden ausgewählt aus der Gruppe bestehend aus einer Einfachbindung, NR, CR₂, O, S oder C=O;
G ist bei jedem Auftreten gleich oder verschieden ausgewählt aus der Gruppe bestehend aus NR, CR₂, O, S oder C=O;
p, q, r sind bei jedem Auftreten gleich oder verschieden und sind ausgewählt aus der Gruppe bestehend aus 0, 1 oder 2;
s, t sind bei jedem Auftreten gleich oder verschieden und sind ausgewählt aus der Gruppe bestehend aus 0 oder 1;
R ist bei jedem Auftreten gleich oder verschieden ausgewählt aus der Gruppe bestehend aus H, D, F, Cl, Br, I, CN, NO₂, N(Ar⁴)₂, N(R¹)₂, OAr⁴, OR¹, SAr⁴, SR¹, C(=O)Ar⁴, C(=O)R¹, P(=O)(Ar⁴)₂, P(Ar⁴)₂, B(Ar⁴)₂, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenylgruppe oder Alkinylgruppe mit 2 bis 40 C-Atomen, die jeweils mit einem oder mehreren Resten R¹ substituiert sein kann und wobei eine oder mehrere nicht-benachbarte CH₂-Gruppen durch R¹C=CR¹, C=O, C=S, C=NR¹, P(=O)(R¹), SO, SO₂, NR¹, O, S oder CONR¹ ersetzt sein können und wobei ein oder mehrere H-Atome durch D, F, Cl, Br, I, CN oder NO₂ ersetzt sein können, einem aromatischen oder heteroaromatischen Ringsystem mit 5 bis 60 aromatischen Ringatomen, das jeweils mit einem oder mehreren Resten R¹ substituiert sein kann, oder einer Aralkyl- oder Heteroaralkylgruppe mit 5 bis 60 aromatischen Ringatomen, die mit einem oder mehreren Resten R¹ substituiert sein kann, oder einer Kombination dieser Systeme; dabei können optional zwei oder mehr Substituenten R, die bevorzugt an dasselbe Kohlenstoffatom oder an benachbarte Kohlenstoffatome gebunden sind, ein monocyclisches oder polycyclisches, aliphatisches, heteroaliphatisches, aromatisches oder heteroaromatisches Ringsystem bilden, das mit einem oder mehreren Resten R¹ substituiert sein kann;
Ar, Ar¹, Ar², Ar³ sind bei jedem Auftreten gleich oder verschieden ein aromatisches oder heteroaromatisches Ringsystem mit 5 bis 40 aromatischen Ringatomen, welches mit einem oder mehreren Resten R substituiert sein kann, wobei für q gleich 0 beide Ar zusammen auch für eine mit mindestens beiden N-Atomen verbundene Gruppe Ar stehen kann;
Ar⁴ ist bei jedem Auftreten gleich oder verschieden ein aromatisches oder heteroaromatisches Ringsystem mit 5 bis 40 aromatischen Ringatomen, welches mit einem oder mehreren Resten R² substituiert sein kann, dabei können zwei Reste Ar⁴, welche an dasselbe N-Atom oder P-Atom binden, auch durch eine Einfachbindung oder eine Brücke ausgewählt aus N(R²), C(R²)₂, O oder S, miteinander verbrückt sein;
R¹ ist bei jedem Auftreten gleich oder verschieden ausgewählt aus der Gruppe bestehend aus H, D, F, Cl, Br, I, CN, NO₂, N(R²)₂, OR², SR², C(=O)R², einer geradkettigen Alkyl-, Alkoxy- oder Thioalkylgruppe mit 1 bis 20 C-Atomen oder einer verzweigten oder cyclischen Alkyl-, Alkoxy- oder Thioalkylgruppe mit 3 bis 20 C-Atomen oder einer Alkenylgruppe oder Alkinylgruppe mit 2 bis 20 C-Atomen, die jeweils mit einem oder mehreren Resten R² substituiert sein kann und wobei eine oder mehrere nichtbenachbarte CH₂-Gruppen durch R²C=CR², C=O, C=S, C=NR², P(=0)(R²), SO, SO₂, NR², O, S oder CONR² ersetzt sein können und wobei ein oder mehrere H-Atome durch D, F, Cl, Br, I, CN oder NO₂ ersetzt sein können, einem aromatischen oder heteroaromatischen Ringsystem mit 5 bis 40 aromatischen Ringatomen, das jeweils mit einem oder mehreren Resten R² substituiert sein kann, oder einer Aralkyl- oder Heteroaralkylgruppe mit 5 bis 40 aromatischen Ringatomen, die mit einem oder mehreren Resten R² substituiert sein kann; dabei können optional zwei Substituenten R¹, die an das gleiche Kohlenstoffatom oder an benachbarte Kohlenstoffatome gebunden sind, ein monocyclisches oder polycyclisches, aliphatisches, heteroaliphatisches, aromatisches oder heteroaromatisches Ringsystem bilden, das mit einem oder mehreren Resten R² substituiert sein kann; und
R² ist bei jedem Auftreten gleich oder verschieden ausgewählt aus der Gruppe bestehend aus H, D, F, CN, einem aliphatischen Kohlenwasserstoffrest mit 1 bis 20 C-Atomen oder einem aromatischen oder heteroaromatischen Ringsystem mit 5 bis 30 aromatischen Ringatomen, in dem ein oder mehrere H-Atome durch D, F oder CN oder durch ein oder mehrere Alkylgruppen mit jeweils 1 bis 10 Kohlenstoffatomen substituiert sein kann; dabei können zwei oder mehr benachbarte Substituenten R² miteinander ein mono- oder polycyclisches, aliphatisches, aromatisches oder heteroaromatisches Ringsystem bilden.

2. Verbindung nach Anspruch 1, **dadurch gekennzeichnet, dass** es eine Verbindung der Formel (2) ist, 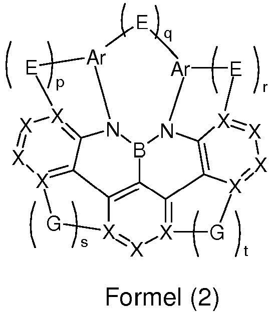 wobei die Symbole und Indizes die in Anspruch 1 genannten Bedeutungen aufweisen und zusätzlich gilt:
X ist bei jedem Auftreten gleich oder verschieden CR, N oder genau zwei benachbarte Gruppen X stehen zusammen für eine Gruppe ausgewählt aus NR, O oder S und die verbleibenden X stehen gleich oder verschieden für CR oder N, wodurch ein Fünfring entsteht; dabei steht X für C oder N oder genau zwei X stehen für N, wenn dort eine Bindung zu E oder G ist; mit der Maßgabe, dass maximal 3 X in einem Cyclus für N stehen.

3. Verbindung nach einem oder mehreren der Ansprüche 1 oder 2, **dadurch gekennzeichnet, dass** es eine Verbindung der Formeln (2-1) bis (2-3) ist, 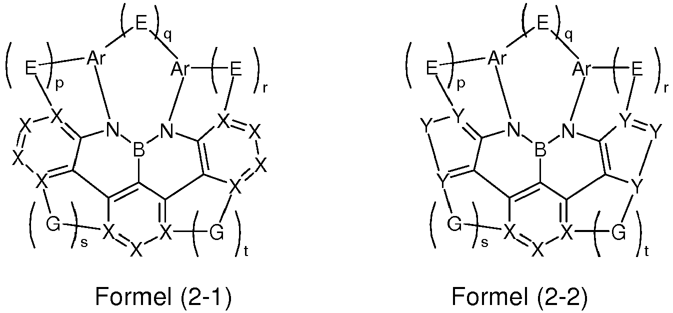 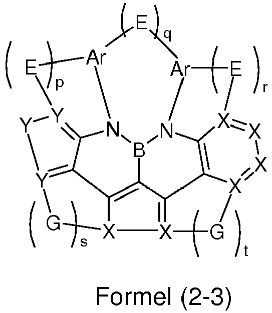 wobei die Symbole und Indizes die in Anspruch 1 genannten Bedeutungen aufweisen und zusätzlich gilt:
X ist bei jedem Auftreten gleich oder verschieden CR oder N, wobei X für C steht, wenn dort eine Bindung zu E oder G ist, und wobei maximal 2 X in einem Cyclus für N stehen;
Y ist bei jedem Auftreten gleich oder verschieden CR, NR, O oder S, wobei Y auch N sein kann, wenn in dem gleichen Cyclus bereits ein Y für NR, O oder S steht, wobei Y für C oder N steht, wenn dort eine Bindung zu E ist.

4. Verbindung nach Anspruch 3, **dadurch gekennzeichnet, dass** die Verbindung eine Verbindung der Formeln (3-1) bis Formel (3-6) ist, 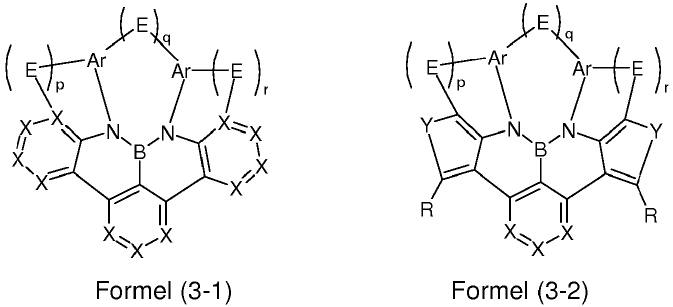 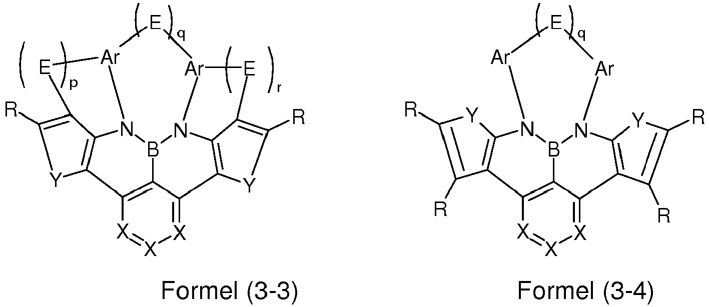 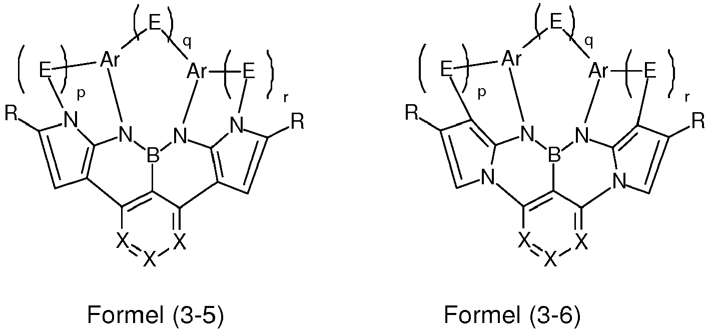 wobei die Symbole und Indizes die in Anspruch 1 genannten Bedeutungen aufweisen, X die in Anspruch 3 genannten Bedeutungen aufweist und zusätzlich gilt:
Y ist in Formeln (3-1) bis (3-4) bei jedem Auftreten gleich oder verschieden NR, O oder S und ist in Formeln (3-5) und (3-6) NR, O oder S, wenn die an Y gebundene Gruppe E nicht vorhanden ist, bzw. ist N, wenn die an Y gebundene Gruppe E vorhanden ist.

5. Verbindung nach einem oder mehreren der Ansprüche 1 bis 3,
**dadurch gekennzeichnet, dass** s und t gleich 0 sind.

6. Verbindung nach einem oder mehreren der Ansprüche 1 bis 5,
**dadurch gekennzeichnet, dass** p und r bei jedem Auftreten gleich oder verschieden ausgewählt sind aus 0 und 1 und q ausgewählt ist aus 0, 1 oder 2.

7. Verbindung nach einem oder mehreren der Ansprüche 1 bis 6, **dadurch gekennzeichnet, dass** die Verbindung eine Verbindung der Formel (5) ist, 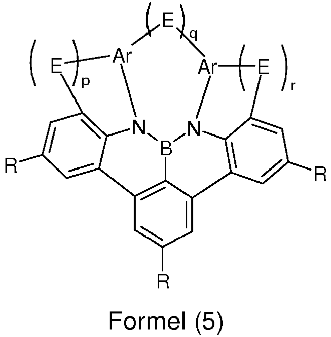 wobei die Symbole und Indizes die in Anspruch 1 genannten Bedeutungen aufweisen.

8. Mischung enthaltend mindestens eine Verbindung nach einem oder mehreren der Ansprüche 1 bis 7 und mindestens eine weitere Verbindung und/oder mindestens ein Lösemittel.

9. Verwendung einer Verbindung nach einem oder mehreren der Ansprüche 1 bis 7 oder einer Mischung nach Anspruch 8 in einer elektronischen Vorrichtung.

10. Elektronische Vorrichtung enthaltend mindestens eine Verbindung nach einem oder mehreren der Ansprüche 1 bis 7 oder eine Mischung nach Anspruch 8.

11. Elektronische Vorrichtung nach Anspruch 10, **dadurch gekennzeichnet, dass** es sich um einer organische Elektrolumineszenzvorrichtung handelt.

12. Elektronische Vorrichtung nach Anspruch 11, **dadurch gekennzeichnet, dass** die Verbindung nach einem oder mehreren der Ansprüche 1 bis 7 in einer emittierenden Schicht, bevorzugt in Kombination mit einem phosphoreszierenden Dotanden und gegebenenfalls einem oder mehreren weiteren Matrixmaterialien, und/oder in einer Lochtransportschicht und/oder einer Elektronentransportschicht eingesetzt wird.

## Claims

1. Compound of formula (1) 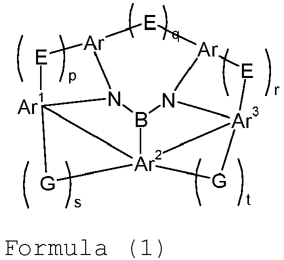 where the symbols and indices used are as follows:
E is the same or different at each instance and is selected from the group consisting of a single bond, NR, CR₂, O, S and C=O;
G is the same or different at each instance and is selected from the group consisting of NR, CR₂, O, S and C=O;
p, q, r are the same or different at each instance and are selected from the group consisting of 0, 1 and 2;
s, t are the same or different at each instance and are selected from the group consisting of 0 and 1;
R is the same or different at each instance and is selected from the group consisting of H, D, F, Cl, Br, I, CN, NO₂, N(Ar⁴)₂, N(R¹)₂, OAr⁴, OR¹, SAr⁴, SR¹, C (=O)Ar⁴, C(=O)R¹, P(=O) (Ar⁴)₂, P(Ar⁴)₂, B(Ar⁴)₂, a straight-chain alkyl, alkoxy or thioalkyl group having 1 to 40 carbon atoms or a branched or cyclic alkyl, alkoxy or thioalkyl group having 3 to 40 carbon atoms or an alkenyl group or alkynyl group having 2 to 40 carbon atoms, each of which may be substituted by one or more R¹ radicals and where one or more nonadjacent CH₂ groups may be replaced by R¹C=CR¹, C=O, C=S, C=NR¹, P(=O) (R¹), SO, SO₂, NR¹, O, S or CONR¹ and where one or more hydrogen atoms may be replaced by D, F, Cl, Br, I, CN or NO₂, an aromatic or heteroaromatic ring system which has 5 to 60 aromatic ring atoms and may be substituted in each case by one or more R¹ radicals, or an aralkyl or heteroaralkyl group which has 5 to 60 aromatic ring atoms and may be substituted by one or more R¹ radicals, or a combination of these systems; at the same time, it is optionally possible for two or more substituents R preferably bonded to the same carbon atom or to adjacent carbon atoms to form a monocyclic or polycyclic, aliphatic, heteroaliphatic, aromatic or heteroaromatic ring system which may be substituted by one or more R¹ radicals;
Ar, Ar¹, Ar², Ar³ are the same or different at each instance and are an aromatic or heteroaromatic ring system which has 5 to 40 aromatic ring atoms and may be substituted by one or more R radicals, where, when q is 0, both Ar together may also be an Ar group bonded to at least both nitrogen atoms;
Ar⁴ is the same or different at each instance and is an aromatic or heteroaromatic ring system which has 5 to 40 aromatic ring atoms and may be substituted by one or more R² radicals; at the same time, two Ar⁴ radicals bonded to the same nitrogen atom or phosphorus atom may also be bridged to one another by a single bond or a bridge selected from N(R²), C(R²)₂, O and S;
R¹ is the same or different at each instance and is selected from the group consisting of H, D, F, Cl, Br, I, CN, NO₂, N(R²)₂, OR², SR², C(=O)R², a straight-chain alkyl, alkoxy or thioalkyl group having 1 to 20 carbon atoms or a branched or cyclic alkyl, alkoxy or thioalkyl group having 3 to 20 carbon atoms or an alkenyl group or alkynyl group having 2 to 20 carbon atoms, each of which may be substituted by one or more R² radicals and where one or more nonadjacent CH₂ groups may be replaced by R²C=CR², C=O, C=S, C=NR², P(=O) (R²), SO, SO₂, NR², O, S or CONR² and where one or more hydrogen atoms may be replaced by D, F, Cl, Br, I, CN or NO₂, an aromatic or heteroaromatic ring system which has 5 to 40 aromatic ring atoms and may be substituted in each case by one or more R² radicals, or an aralkyl or heteroaralkyl group which has 5 to 40 aromatic ring atoms and may be substituted by one or more R² radicals; at the same time, it is optionally possible for two substituents R¹ bonded to the same carbon atom or to adjacent carbon atoms to form a monocyclic or polycyclic, aliphatic, heteroaliphatic, aromatic or heteroaromatic ring system which may be substituted by one or more R² radicals; and
R² is the same or different at each instance and is selected from the group consisting of H, D, F, CN, an aliphatic hydrocarbyl radical having 1 to 20 carbon atoms, or an aromatic or heteroaromatic ring system having 5 to 30 aromatic ring atoms in which one or more hydrogen atoms may be substituted by D, F or CN or by one or more alkyl groups each having 1 to 10 carbon atoms; at the same time, two or more adjacent substituents R² together may form a mono- or polycyclic, aliphatic, aromatic or heteroaromatic ring system.

2. Compound according to Claim 1, **characterized in that** it is a compound of the formula (2) 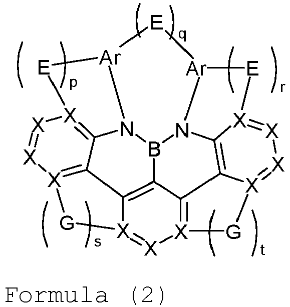 where the symbols and indices have the definitions given in claim 1 and in addition:
X is the same or different at each instance and is CR, N, or exactly two adjacent X groups together are a group selected from NR, O and S and the remaining X are the same or different and are CR or N, forming a five-membered ring; at the same time, X is C or N or exactly two X are N when there is a bond to E or G thereon; with the proviso that not more than 3 X in any cycle are N.

3. Compound according to one or more of Claims 1 and 2, **characterized in that** it is a compound of the formulae (2-1) to (2-3) 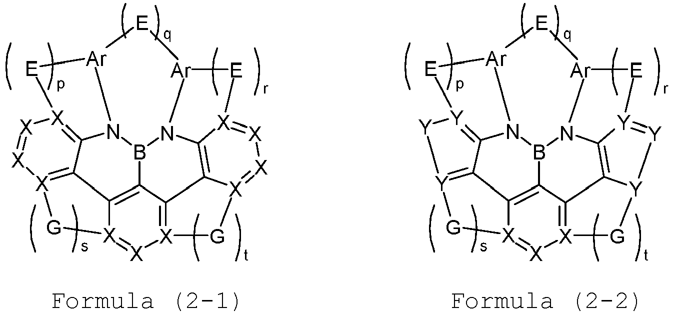 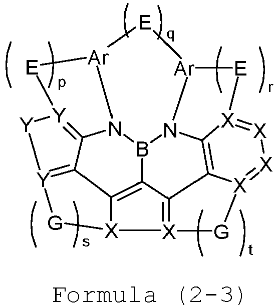 where the symbols and indices have the definitions given in Claim 1 and in addition:
X is the same or different at each instance and is CR or N, where X is C when there is a bond to E or G thereon, and where not more than 2 X in any cycle are N;
Y is the same or different at each instance and is CR, NR, O or S, where Y may also be N when one Y in the same cycle is already NR, O or S, where Y is C or N when there is a bond to E thereon.

4. Compound according to Claim 3, **characterized in that** the compound is a compound of the formulae (3-1) to formula (3-6) 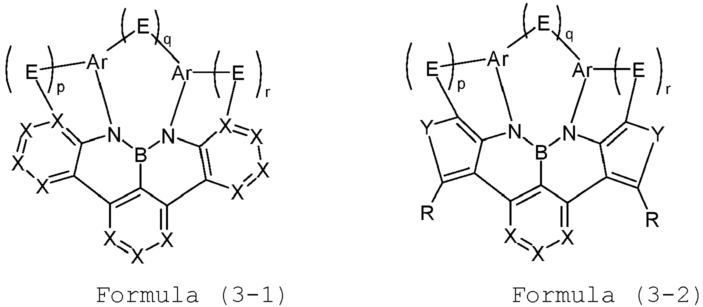 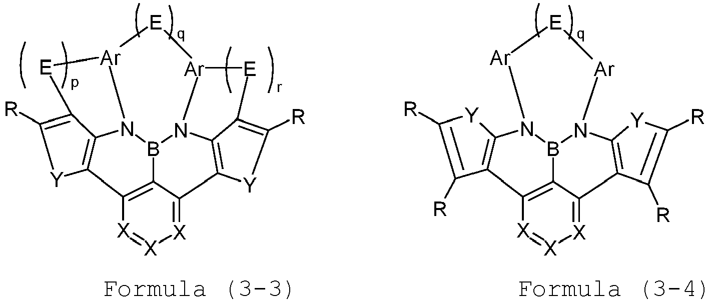 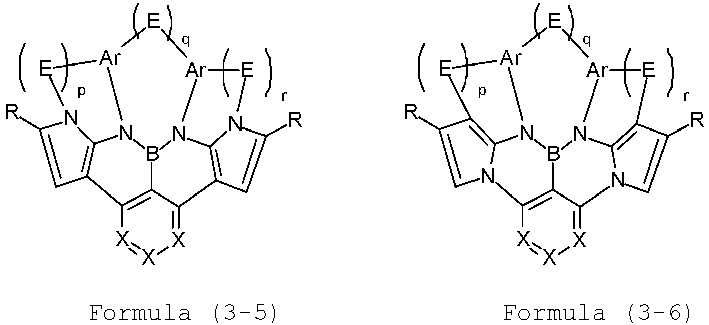 where the symbols and indices have the definitions given in Claim 1, X has the definitions given in Claim 3, and in addition:
Y in formulae (3-1) to (3-4) is the same or different at each instance and is NR, O or S, and in formulae (3-5) and (3-6) is NR, O or S when the E group bonded to Y is absent, or is N when the E group bonded to Y is present.

5. Compound according to one or more of Claims 1 to 3, **characterized in that** s and t are 0.

6. Compound according to one or more of Claims 1 to 5, **characterized in that** p and r are the same or different at each instance and are selected from 0 and 1, and q is selected from 0, 1 and 2.

7. Compound according to one or more of Claims 1 to 6, **characterized in that** the compound is a compound of the formula (5) 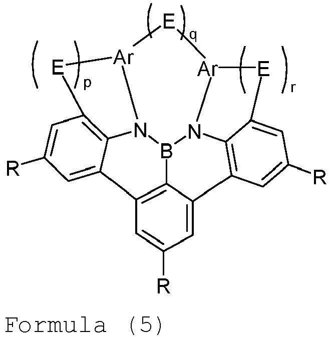 where the symbols and indices have the definitions given in Claim 1.

8. Mixture comprising at least one compound according to one or more of Claims 1 to 7 and at least one further compound and/or at least one solvent.

9. Use of a compound according to one or more of Claims 1 to 7 or a mixture according to Claim 8 in an electronic device.

10. Electronic device comprising at least one compound according to one or more of Claims 1 to 7 or a mixture according to Claim 8.

11. Electronic device according to Claim 10, **characterized in that** it is an organic electroluminescent device.

12. Electronic device according to Claim 11, **characterized in that** the compound according to one or more of Claims 1 to 7 is used in an emitting layer, preferably in combination with a phosphorescent dopant and optionally one or more further matrix materials, and/or in a hole transport layer and/or an electron transport layer.

## Revendications

1. Composé selon la formule (1), 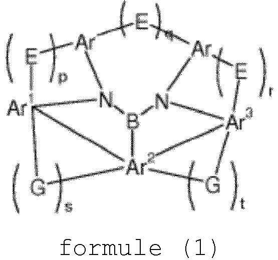 ce qui suit s'appliquant aux symboles et indices utilisés :
E, identique ou différent en chaque occurrence, étant choisi dans le groupe constitué par une simple liaison, NR, CR₂, O, S et C=O ;
G, identique ou différent en chaque occurrence, étant choisi dans le groupe constitué par NR, CR₂, O, S et C=O ;
p, q, r, identiques ou différents en chaque occurrence, étant choisis dans le groupe constitué par 0, 1 et 2 ;
s, t, identiques ou différents en chaque occurrence, étant choisis dans le groupe constitué par 0 et 1 ;
R, identique ou différent en chaque occurrence, étant choisi dans le groupe constitué par H, D, F, Cl, Br, I, CN, NO₂, N(Ar⁴)₂, N(R¹)₂, OAr⁴, OR¹, SAr⁴, SR¹, C(=O)Ar⁴, C(=O)R¹, P(=O) (Ar⁴)₂, P(Ar⁴)₂, B(Ar⁴)₂, un groupe linéaire alkyle, alcoxy ou thioalkyle comportant 1 à 40 atomes de C ou un groupe ramifié ou cyclique alkyle, alcoxy ou thioalkyle comportant 3 à 40 atomes de C ou un groupe alcényle ou alcynyle comportant 2 à 40 atomes de C, qui peut à chaque fois être substitué par un ou plusieurs radicaux R¹, et un ou plusieurs groupes CH₂ non voisins pouvant être remplacés par R¹C=CR¹, C=O, C=S, C=NR¹, P(=O)(R¹), SO, SO₂, NR¹, O, S ou CONR¹ et un ou plusieurs atomes de H pouvant être remplacés par D, F, Cl, Br, I, CN ou NO₂, un système cyclique aromatique ou hétéroaromatique comportant 5 à 60 atomes de cycle aromatique, qui peut à chaque fois être substitué par un ou plusieurs radicaux R¹, ou un groupe aralkyle ou hétéroaralkyle comportant 5 à 60 atomes de cycle aromatique, qui peut être substitué par un ou plusieurs radicaux R¹, ou une combinaison de ces systèmes ; à cet égard deux substituants R ou plus, qui sont liés préférablement au même atome de carbone ou à des atomes de carbone voisins, peuvent éventuellement former un système cyclique aliphatique, hétéroaliphatique, aromatique ou hétéroaromatique, monocyclique ou polycyclique, qui peut être substitué par un ou plusieurs radicaux R¹ ;
Ar, Ar¹, Ar², Ar³, identiques ou différents en chaque occurrence, étant un système cyclique aromatique ou hétéroaromatique comportant 5 à 40 atomes de cycle aromatique, qui peut être substitué par un ou plusieurs radicaux R, dans lequel pour q égal à 0, les deux Ar peuvent représenter ensemble également un groupe Ar relié avec au moins les deux atomes de N,
Ar⁴, identique ou différent en chaque occurrence, étant un système cyclique aromatique ou hétéroaromatique comportant 5 à 40 atomes de cycle aromatique, qui peut être substitué par un ou plusieurs radicaux R², à cet égard deux radicaux Ar⁴ qui sont liés au même atome de N ou au même atome de P, peuvent également être pontés l'un à l'autre par une simple liaison ou par un pont choisi parmi N(R²), C(R²)₂, O ou S ;
R¹, identique ou différent en chaque occurrence, étant choisi dans le groupe constitué par H, D, F, Cl, Br, I, CN, NO₂, N(R²)₂, OR², SR², C(=O)R², un groupe linéaire alkyle, alcoxy ou thioalkyle comportant 1 à 20 atomes de C ou un groupe ramifié ou cyclique alkyle, alcoxy ou thioalkyle comportant 3 à 20 atomes de C ou un groupe alcényle ou alcynyle comportant 2 à 20 atomes de C, qui peut à chaque fois être substitué par un ou plusieurs radicaux R², et un ou plusieurs groupes CH₂ non voisins pouvant être remplacés par R²C=CR², C=O, C=S, C=NR², P(=O) (R²), SO, SO₂, NR², O, S ou CONR² et un ou plusieurs atomes de H pouvant être remplacés par D, F, Cl, Br, I, CN ou NO₂, un système cyclique aromatique ou hétéroaromatique comportant 5 à 40 atomes de cycle aromatique, qui peut à chaque fois être substitué par un ou plusieurs radicaux R², ou un groupe aralkyle ou hétéroaralkyle comportant 5 à 40 atomes de cycle aromatique qui peut être substitué par un ou plusieurs radicaux R² ; à cet égard deux substituants R¹, qui sont liés au même atome de carbone ou à des atomes de carbone voisins, peuvent éventuellement former un système cyclique aliphatique, hétéroaliphatique, aromatique ou hétéroaromatique, monocyclique ou polycyclique, qui peut être substitué par un ou plusieurs radicaux R² ; et
R², identique ou différent chaque occurrence, étant choisi dans le groupe constitué par H, D, F, CN, un radical hydrocarboné aliphatique comportant 1 à 20 atomes de C ou un système cyclique aromatique ou hétéroaromatique comportant 5 à 30 atomes de cycle aromatique, dans lequel un ou plusieurs atomes de H peuvent être substitués par D, F ou CN ou par un ou plusieurs groupes alkyle comportant à chaque fois 1 à 10 atomes de carbone ; à cet égard deux substituants R² voisins ou plus peuvent former ensemble un système cyclique aliphatique, aromatique ou hétéroaromatique, monocyclique ou polycyclique.

2. Composé selon la revendication 1, **caractérisé en ce qu'**il est un composé de formule (2), 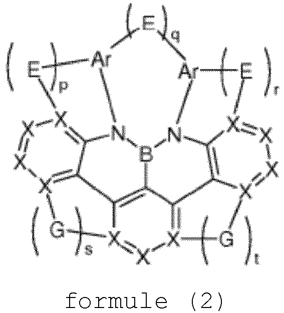 les symboles et indices présentant les significations mentionnées dans la revendication 1 et de plus :
X, identique ou différent chaque occurrence, étant CR, N ou exactement deux groupes X voisins représentant ensemble un groupe choisi parmi NR, O et S et les X restants, identiques ou différents, représentant CR ou N, un cycle à cinq chaînons étant ainsi formé ; à cet égard, X représente C ou N ou exactement deux X représentent N, lorsqu'il y a là une liaison à E ou G ; à la condition qu'au maximum 3 X dans un cycle représentent N.

3. Composé selon l'une ou plusieurs des revendications 1 et 2, **caractérisé en ce qu'**il est un composé de formule (2-1) à (2-3), 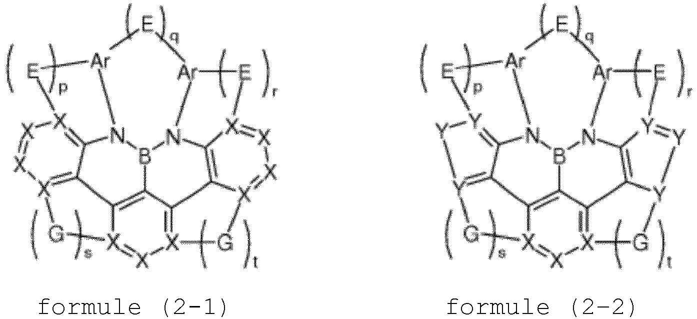 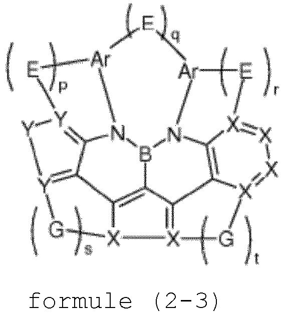 les symboles et indices présentant les significations mentionnées dans la revendication 1 et de plus :
X, identique ou différent en chaque occurrence, étant CR ou N, X représentant C lorsqu'il y a là une liaison à E ou G, et au maximum 2 X représentant N dans un cycle ;
Y, identique ou différent en chaque occurrence, étant CR, NR, O ou S, Y pouvant également être N, lorsque dans le même cycle déjà un Y représente NR, O ou S, Y représentant C ou N, lorsqu'il y a là une liaison à E.

4. Composé selon la revendication 3, **caractérisé en ce que** le composé est un composé de la formule (3-1) à la formule (3-6), 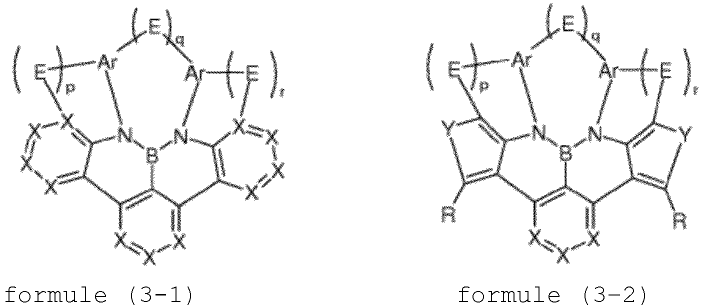 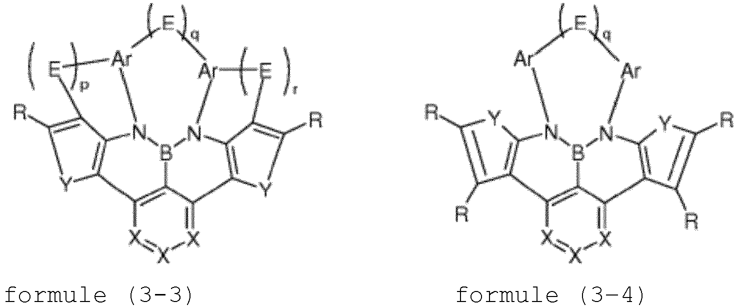 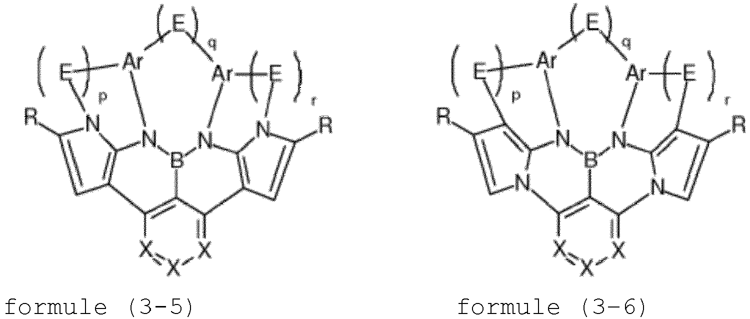 les symboles et indices présentant les significations mentionnées dans la revendication 1, X présentant les significations mentionnées dans la revendication 3 et de plus :
Y, identique ou différent en chaque occurrence dans les formules (3-1) à (3-4), étant NR, O ou S et étant NR, O ou S dans les formules (3-5) et (3-6), lorsque le groupe E lié à Y n'est pas présent, respectivement étant N, lorsque le groupe E lié à Y est présent.

5. Composé selon l'une ou plusieurs des revendications 1 à 3, **caractérisé en ce que** s et t sont égaux à 0.

6. Composé selon l'une ou plusieurs des revendications 1 à 5, **caractérisé en ce que** p et r, identiques ou différents en chaque occurrence, sont choisis parmi 0 et 1 et q est choisi parmi 0, 1 et 2.

7. Composé selon l'une ou plusieurs des revendications 1 à 6, **caractérisé en ce que** le composé est un composé de formule (5), 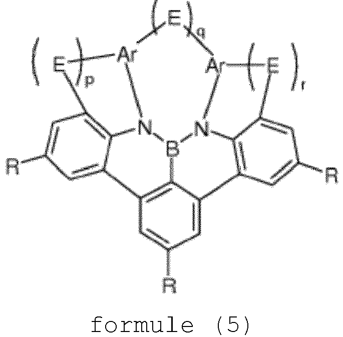 les symboles et indices présentant les significations mentionnées dans la revendication 1.

8. Mélange contenant au moins un composé selon l'une ou plusieurs des revendications 1 à 7 et au moins un composé supplémentaire et/ou au moins un solvant.

9. Utilisation d'un composé selon l'une ou plusieurs des revendications 1 à 7 ou d'un mélange selon la revendication 8 dans un dispositif électronique.

10. Dispositif électronique contenant au moins un composé selon l'une ou plusieurs des revendications 1 à 7 ou un mélange selon la revendication 8.

11. Dispositif électronique selon la revendication 10, **caractérisé en ce qu'**il s'agit d'un dispositif organiqueélectroluminescent.

12. Dispositif électronique selon la revendication 11, **caractérisé en ce que** le composé selon l'une ou plusieurs des revendications 1 à 7 est utilisé dans une couche émettrice, préférablement en combinaison avec un dopant phosphorescent et éventuellement avec un ou plusieurs matériaux de matrice supplémentaires, et/ou dans une couche de transport de trous et/ou dans une couche de transport d'électrons.
